# EUROPEAN PATENT SPECIFICATION

(11) **EP 3 751 464 B1**
(45) Date of publication and mention of the grant of the patent: **02.09.2026**
(21) Application number: 20188881.5
(22) Date of filing: 11.02.2015
(51) Int. Cl.: H10W 72/50, G06K 19/077

(54) **TRANSPONDER CHIP MODULES AND METHOD OF MAKING SAME**
TRANSPONDERCHIPMODULE UND VERFAHREN ZU DEREN HERSTELLUNG
MODULES DE PUCES DE TRANSPONDEUR ET LEUR PROCÉDÉ DE FABRICATION

(30) Priority: 27.02.2014 US 201461945689 P; 19.05.2014 US 201414281876; 12.07.2014 US 201462023874 P; 23.07.2014 US 201462028302 P; 10.08.2014 US 201462035430 P; 20.08.2014 US 201462039562 P; 21.08.2014 US 201414465815; 01.09.2014 US 201462044394 P; 10.09.2014 US 201462048373 P; 22.09.2014 US 201414492113; 08.10.2014 US 201462061689 P; 27.10.2014 US 201414523993; 16.11.2014 US 201462080332 P; 24.11.2014 US 201414551376; 07.12.2014 US 201462088598 P; 24.12.2014 US 201462096559 P; 12.01.2015 US 201562102103 P; 18.01.2015 US 201562104759 P
(43) Date of publication of application: 16.12.2020
(62) Document number(s) of the earlier application(s) in accordance with Art. 76 EPC: 15704298.7 / 3 111 374
(73) Proprietor: FÉINICS AMATECH TEORANTA, Dublin 16, D16 X8C3 (IE)
(72) Inventor: Lotya, Mustafa, Celbridge, County Kildare (IE); Finn, David, Tourmakeady, County Mayo (IE); Molloy, Darren, Boula Hedford, County Galway (IE)
(74) Representative: Cremer & Cremer

(56) References cited:
- WO-A1-2011/157693
- US-A1- 2012 038 445
- US-A1- 2013 140 370

## Description

### TECHNICAL FIELD

The invention relates to a transponder chip module and to a method of making a transponder chip module. The transponder chip modules may be implanted, inserted or placed in secure documents, such as smartcards. Thus, broadly, the disclosure relates to RFID devices including "secure documents" or "RFID tags" such as electronic passports, electronic ID cards and smartcards (or payment cards, electronic tickets, chip cards and the like) having RFID (radio frequency identification) chips or chip modules (CM) capable of operating in a "contactless" mode (ISO 14443 or NFC/ISO 15693) including dual interface (DI) smartcards and secure documents which also operate in contact mode (ISO 7816-2).

### BACKGROUND

A prior art dual interface (DI or DIF) smartcard (or smart card; SC) may generally comprise:
- an antenna module (AM) having a module antenna (MA) for contactless operation and contact pads (CP) for contact operation,
- a card body (CB) having layers of plastic or metal, or combinations thereof, and
- a booster antenna (BA) disposed in the card body (or "inlay"). Some examples of smart cards having booster antennas are disclosed in US 14020884 filed 08 Sep 2013 **(**US 20140091149, 03 Apr 2014)

A prior art antenna module (AM), which may be referred to as a transponder chip module (TCM) or RFID module, may generally comprise:
- a module tape (MT) or chip carrier tape (CCT), more generally, simply a "substrate";
- a contact pad array (CPA) comprising 6 or 8 contact pads (CP, or "ISO pads") disposed on a "face up side" or "contact side" (or surface) of the module tape (MT), for interfacing with a contact reader in a contact mode (ISO 7816);
- an RFID chip (CM, IC) which may be a bare, unpackaged silicon die or a chip module (a die with leadframe, interposer, carrier or the like) disposed on a "face down side" or "bond side" or "chip side" (or surface) of the module tape (MT);
- a module antenna (MA) or antenna structure (AS) disposed on the face down side of the module tape (MT) for implementing a contactless interface, such as ISO 14443 and NFC/ISO 15693 with a contactless reader or other RFID device.

An antenna module (AM) which may be able to operate without a booster antenna (BA) in the card body (CB) may be referred to as a transponder chip module (TCM), or as a transponder IC module.

The antenna module (AM) or transponder chip module (TCM) may be generally rectangular, having four sides, and measuring approximately 8.2 mm x 10.8 mm for a 6-contact module and 11.8 mm x 13.0 mm for an 8-contact module. Alternatively, the transponder chip module (TCM) may be round, elliptical, or other non-rectangular shape. When operating in a contactless mode, the antenna module (AM) or transponder chip module (TCM) may be powered by RF from an external RFID reader, and may also communicate by RF with the external RFID reader.

As is known from prior art, a module antenna (MA) may be disposed on the module tape (MT) for implementing a contactless interface, such as ISO 14443 and NFC/ISO 15693. Contact pads (CP) may be disposed on the module tape (MT) for implementing a contact interface, such as ISO 7816. The contact pads (CP) may or may not be perforated. The module tape (MT) may comprise a pattern of interconnects (conductive traces and pads) to which the RFID chip (CM, IC) and contact pads (CP) may be connected. The module tape (MT) may be "single-sided", having a conductive layer (or cladding, or foil) on only one side thereof, such as the "face-up" side thereof, such as for the contact pads (CP). The module tape (MT) may be "double-sided", having conductive layers (or claddings, or foils) on both sides thereof. A conductive layer on the "face-down" side of the module tape (MT) may be etched to form a module antenna (MA) having a number of tracks (traces) separated by spaces.

The module antenna (MA) may be wire-wound, or etched, for example:
- The module antenna (MA) may comprise several turns of wire, such as 50 µm diameter insulated wire. Reference may be made to US 6,378,774 (2002, Toppan), for example FIGs. 12A, B thereof.
- The module antenna (MA) may be a chemically-etched planar antenna (PA) structure. Reference may be made to US 8,100,337 (2012, SPS), for example FIG. 3 thereof.
- The module antenna (MA) may comprise a laser-etched planar antenna (PA) structure (LES). Reference may be made to US 14281876 filed 19 May 2014 (US 20140284386, 25 Sep 2014).

A planar antenna (PA) structure, or simply "planar antenna (PA)", whether chemically-etched (CES) or laser-etched (LES), is a type of antenna structure (AS) and may comprise a long conductive trace or track having two ends, in the form of a planar, rectangular spiral, disposed in an outer area of a module tape (MT), surrounding the RFID chip on the face-down side of the module tape. This will result in a number of traces or tracks (actually, one long spiraling trace or track), separated by spaces (actually, one long spiraling space). The track (or trace) width may be approximately 100 µm. Generally, with laser etching, the track width may be made narrower and the spaces between traces can be made smaller than with chemical etching. For example, whereas with chemical etching the spaces between tracks may be limited to 100µm, with laser etching spacing of 25 µm or less may be achieved. The planar antenna may be fabricated on other than the module tape, such as on a separate substrate.

In the prior art the (two) ends of the module antenna (MA) may be connected, either directly or indirectly to corresponding terminals (LA, LB) of the RFID chip (IC, CM). For example, one or both ends of the module antenna (MA) may be connected to bond pads or interconnect traces on the face-down side of the module tape (MT), to which the terminals of the RFID chip (IC, CM) may also be connected.

Alternatively, one or both ends of the module antenna (MA) may be connected (to the RFID chip) via electrically conductive structures, which may be referred to as "contact bridges" or "connection bridges", disposed on the face-up side of the module tape (MT), and which may be formed from the same conductive layer as the contact pads (CP). Some examples of connection bridges may be found in
- US 20130146670 (2013-06-13, Grieshofer et al; "Infineon")
- commonly-owned, copending US 20140104133 published 17 Apr 2014
- commonly-owned, copending US 14523993 filed 27 Oct 2014 (US 20150129665 A1)
- commonly-owned, copending US 14551376 filed 24 Nov 2014 (US 20150136858 A1)

Further relevant prior art can be found in WO2011/157693, US2013/140370 and US2012/038445.

The antenna or antenna structure AS may be laser etched from a copper layer (cladding or foil), which may have a thickness of approximately 18 µm - 35 µm, but may be approximately 12 µm, which may be less than the skin depth of copper (~18 µm), forming a number of tracks separated by a distance approximately equal to the width of the laser beam, or dictated by the kerf of the laser, such as approximately 25 µm. (The laser burns away a portion of material when it cuts through. This is known as the laser kerf. The kerf size will be greater than the theoretical spot size of the focused laser beam and will depend on the material properties of the target and laser settings.) Subsequent to laser etching, the antenna structure may be plated, which may reduce the distance between tracks to approximately 20 µm (for example). This may result in increased performance of the antenna structure, and the overall antenna module AM or transponder chip module (TCM), and reduce performance constraints on the performance of a booster antenna (BA) in the card body (CB) of the smartcard (SC).

A module antenna (MA) connected to an RFID chip (CM), typically on a substrate or module tape (MT), may be referred to as a "transponder". Generally, such a transponder is a "passive" transponder which does not have its own power source (e.g., battery), but rather which receives (harvests) its operating power from an external reader (interrogator) rather, for example, from a battery. An "active transponder" may have its own internal power source, such as a battery.

### SUMMARY

It is a general object of the invention to provide improved transponder chip modules (TCM) and improved techniques for manufacturing transponder chip modules (TCM).

The invention is claimed in the claims, claim 1 claiming a transponder chip module and claim 11 claiming a method of making a transponder chip module.

Various techniques are disclosed herein- however, not all might be claimed - to improve the construction and performance of transponder chip modules, such as (but not limited to):
- the use of connection bridges extending both parallel to and perpendicular to the insertion direction
- coupling frames incorporated into the module tape of the transponder chip module
- using multiple antenna structures to form the module antenna
- forming the module antenna (planar antenna) on an antenna substrate which is separate from the module tape carrying the contact pads (and connection bridges)
- segmenting metal remaining within an interior area of an etched planar antenna
- making connections through the module tape to the undersides of isolated conductive features such as contact pads located on the face-up side of the module tape
- stamped leadframe-type techniques for forming the isolated metal features

According to the invention, generally, a module tape (MT2) has contact pads (CP) on one side thereof and a connection bridge (CBR) on another side thereof, and is joined with a module tape (MT1) having a planar antenna (PA) on a bottom surface thereof.

According to some examples, a method of connecting a planar antenna (PA) of a transponder chip module (TCM) to an RFID chip (IC) in the module may comprise: connecting an inner end (IE) of the planar antenna by wire bonding to the RFID chip; and may be characterized by: connecting an outer end (OE) of the planar antenna by wire bonding to the RFID chip.

According to the invention, a transponder chip module (TCM) comprises: a first module tape (MT1) having an antenna structure (AS) on a bottom surface thereof; and a second module tape (MT2) having contact pads (CP) on first, top surface thereof and a connection bridge (CBR) on a second, bottom surface thereof, wherein the second module tape is joined to the first module tape in a stacked manner. The transponder chip module further comprises: conductive elements extending through the second module tape and aligned with and being in contact with at least some of the contact pads.

The transponder chip module may further comprise: through holes (TH) extending through the first module tape and being aligned with the conductive elements extending through the second module tape. The transponder chip module may further comprise: through holes (TH) extending through the first module tape and being aligned with outer and inner portions of the connection bridge. The transponder chip module may further comprise: an opening (OP) extending through the first module tape allowing mounting of an RFID chip (IC) on the second module tape.

According to the invention, a method of making a transponder chip module (TCM) comprises: providing a first module tape (MT1) having an antenna structure (AS) on a bottom surface thereof; providing a second module tape (MT2) having contact pads (CP) on first, top surface thereof and a connection bridge (CBR) on a second, bottom surface thereof; joining the second module tape (MT2) to the first module tape (MT1) in a stacked manner; and providing conductive elements extending through the second module tape and being aligned with and being in contact with at least some of the contact pads.

The method may further comprise: providing through holes (TH) extending through the first module tape and being aligned with the conductive elements extending through the second module tape. The method may further comprise: providing through holes (TH) extending through the first module tape (MT1) and being aligned with outer and inner portions of the connection bridge. The method may further comprise: providing an opening (OP) extending through the first module tape allowing mounting of an RFID chip (IC) on the second module tape.

In their various embodiments, the invention(s) described herein may relate to industrial and commercial industries, such RFID applications, payment smartcards, electronic passports, identity cards, access control cards, wearable devices the like.

Other objects, features and advantages of the invention(s) disclosed herein, and their various embodiments, may become apparent in light of the descriptions of some exemplary embodiments that follows.

### BRIEF DESCRIPTION OF THE DRAWINGS

Reference will be made in detail to embodiments of the disclosure, non-limiting examples of which may be illustrated in the accompanying drawing figures (FIGs). Some figures may be in the form of diagrams. Some elements in the figures may be exaggerated, others may be omitted, for illustrative clarity.

Any text (legends, notes, reference numerals and the like) appearing on the drawings are incorporated by reference herein.

Some elements may be referred to with letters ("AM", "BA", "CB", "CCM", "CM", "MA", "MT", "PA", "TCM", etc.) rather than or in addition to numerals. Some similar (including substantially identical) elements in various embodiments may be similarly numbered, with a given numeral such as "310", followed by different letters such as "A", "B", "C", etc. (resulting in "310A", "310B", "310C"), and variations thereof, and may collectively (all of them at once) referred to simply by the numeral ("310").
**FIGs. 1 to 2** are not part of the invention but are included for illustration purposes only.
**FIG. 1** is a diagram (cross-sectional view) of a dual-interface smart card (SC) and readers.
**FIG. 1A** is a diagram (plan view) showing the ISO-7816 specification for contacts.
**FIG. 1B** is a diagram (plan view) of an exemplary 8-pad pattern for ISO-7816 contacts.
**FIG. 1C** is a diagram (plan view) of an exemplary 6-pad pattern for ISO-7816 contacts.
**FIG. 1D** is a diagram (plan view) of a smart card (SC).
**FIG. 2** is a diagram (partial perspective view) of a module tape (MT) for an antenna module (AM) having a connection bridge (CBR).
**FIG. 2B** is a diagram (plan view) of a contact side of a dual-interface antenna module (AM) or transponder chip module (TCM).
**FIG. 5H** is a diagram (exploded cross-sectional) view of a transponder chip module according to the invention having two module tapes (MT1, MT2).
**FIG. 5I** is a diagram (plan view) of a coupling frame doubling as a connection bridge.
**FIG. 5J** is a diagram (plan view) of a coupling frame having a connection bridge disposed in its slit (S).
**FIGs. 8A, 8B, 8C** are diagrams (cross-sectional views) illustrating a method of making connections through a substrate.
**FIGs. 8D, 8E, 8F** are diagrams (cross-sectional views) illustrating a method of making connections through a substrate.
**FIG. 9** is a diagram (top view) showing leadframe (LF) having an arrangement of contact pads (CP; **C1-C8**) and connection bridges (CBR) which may be formed by a stamping process.
**FIG. 9A** is a diagram (exploded cross-sectional view) taken on a line A-A through **FIG. 9****,** showing a leadframe (LF) being assembled to an antenna substrate (AS).

### DETAILED DESCRIPTION

Various embodiments (or examples) may be described to illustrate teachings of the invention(s), and should be construed as illustrative rather than limiting. It should be understood that it is not intended to limit the invention(s) to these particular embodiments. It should be understood that some individual features of various embodiments may be combined in different ways than shown, with one another. Reference herein to "one embodiment", "an embodiment", or similar formulations, may mean that a particular feature, structure, operation, or characteristic described in connection with the embodiment is included in at least one embodiment of the present invention. Some embodiments may not be explicitly designated as such ("an embodiment").

The embodiments and aspects thereof may be described and illustrated in conjunction with systems, devices and methods which are meant to be exemplary and illustrative, not limiting in scope. Specific configurations and details may be set forth in order to provide an understanding of the invention(s). However, it should be apparent to one skilled in the art that the invention(s) may be practiced without some of the specific details being presented herein. Furthermore, some well-known steps or components may be described only generally, or even omitted, for the sake of illustrative clarity. Elements referred to in the singular (e.g., "a widget") may be interpreted to include the possibility of plural instances of the element (e.g., "at least one widget"), unless explicitly otherwise stated (e.g., "one and only one widget").

In the following descriptions, some specific details may be set forth in order to provide an understanding of the invention(s) disclosed herein. It should be apparent to those skilled in the art that these invention(s) may be practiced without these specific details. Any dimensions and materials or processes set forth herein should be considered to be approximate and exemplary, unless otherwise indicated. Headings (typically underlined) may be provided as an aid to the reader, and should not be construed as limiting.

Some processes may be presented and described in a series (sequence) of steps. It should be understood that the sequence of steps is exemplary, and that the steps may be performed in a different order than presented, some steps which are described may be omitted, and some additional steps may be omitted from the sequence and may be described elsewhere.

Reference may be made to disclosures of prior patents, publications and applications. Some text and drawings from those sources may be presented herein, but may be modified, edited or commented to blend more smoothly with the disclosure of the present application.

As used herein, any one of the terms "transponder", "tag", "smart card", "data carrier", "wearable device" and the like, may be interpreted to refer to any other of the devices similar thereto which operate under ISO 14443 or similar RFID standard. The following standards are referenced herein:
- ISO/IEC 7810 is an ISO standard that defines the physical characteristics for identification cards. The characteristics specified include: (i) physical dimensions, (ii) resistance to bending, flame, chemicals, temperature and humidity, and (iii) toxicity. The standard includes test methods for resistance to heat.
- ISO/IEC 14443 (Identification cards - Contactless integrated circuit cards - Proximity cards) is an international standard that defines proximity cards used for identification, and the transmission protocols for communicating with it.
- ISO/IEC 15693 is an ISO standard for vicinity cards, i.e. cards which can be read from a greater distance as compared to proximity cards.
- ISO/IEC 7816 is an international standard related to electronic identification cards with contacts, especially smart cards.
- EMV standards define the interaction at the physical, electrical, data and application levels between IC cards and IC card processing devices for financial transactions. There are standards based on ISO/IEC 7816 for contact cards, and standards based on ISO/IEC 14443 for contactless cards.

A typical transponder chip module (TCM) described herein comprises:
(i) a substrate, such as an epoxy-glass substrate, which is referred to as a module tape (MT) or may be referred to as a chip carrier tape (CCT) and which may function as an inlay substrate;
(ii) optionally an RFID chip (CM, IC) disposed on the substrate; and
(iii) a planar antenna (PA), or simply antenna structure (AS), which may be a laser-etched antenna structure (LES) or a chemically-etched antenna structure (CES) serving as a module antenna (MA) for the transponder chip module (TCM).

When "chip module" is referred to herein, it should be taken to include "chip", and vice versa, unless explicitly otherwise stated. When "transponder chip module" (TCM) is referred to herein, it should be taken to include "antenna module" (AM), and vice versa, unless explicitly otherwise stated. The transponder chip module (TCM) may also be referred to as a "transponder IC module". A "chip module" (die and carrier) with a planar (etched) antenna structure (PA, AS, LES, CES) and connected thereto may be referred to as a transponder chip module (TCM).

When "module tape" is referred to herein, it generally refers to a module tape (MT) or chip carrier tape (CCT) comprising an epoxy-glass substrate having metallization (typically a copper layer) on one or both sides thereof. The module tape (MT) may comprise insulating (electrically non-conductive) materials other than epoxy-glass, and provides a substrate for supporting (and interconnecting) various components of the transponder chip module (TCM) with one another.

The combination of a module tape (MT) and a module antenna (MA) may be referred to as an "antenna substrate" (AS). The module antenna (MA) may comprise an etched planar antenna (PA) in the form of a generally rectangular spiral having a number of turns, comprising tracks (traces) separated by spaces. Some planar antennas may be formed by either chemical etching or laser etching (ablation). Generally, smaller track widths and smaller spaces between tracks can be achieved with laser etching - for example, the planar antenna may have a track width of less than 100 µm, and a spacing between adjacent tracks of less than 75 µm.

The module antenna (MA) may comprise two (or more) antenna structures, such as two antenna structures connected in series or parallel with one another, or one main antenna structure and capacitive stubs connected to the ends of the antenna structure. A capacitor (CAP) may be connected with the module antenna (MA).

Some components and features on either side of the module tape (MT), such as the contact pads (CP), connection bridges (CBR) and antenna structure (AS), may be laser-etched or chemically-etched. Bond pads and interconnect traces may also be formed by etching on the bottom face-down side of the module tape. An antenna incorporated directly on the RFID chip may inductively couple with the planar (etched) antenna structure (AS, PA) on the face-down (chip or bond) side of the module tape (MT).

Contact side metallization (CSM) may be referred to as a "faceplate" for the transponder chip module, and may be formed by stamping a metal sheet or by etching a conductive layer (CL) on the module tape (MT).

The term "layer" may be applied to any metal surface such as copper cladding or foil which may have a thickness of approximately 35 µm and which may be etched to form isolated conductive features (such as contact pads) or a planar antenna. The term "layer" may also be applied to a metal sheet which may have a thickness of approximately 70 µm and which may be stamped to form contact side metallization (such as contact pads and connection bridges). Some of these terms may be used interchangeably with one another. For example, the term "foil" may refer to a sheet or a cladding, depending on the context.

Generally, any dimensions set forth herein are approximate, and materials set forth herein are intended to be exemplary. Conventional abbreviations such as "cm" for centimeter", "mm" for millimeter, "µm" for micron, and "nm" for nanometer may be used.

**FIG.s 1** to **2** are included for illustrative and explanatory purposes and do not form part of the invention.

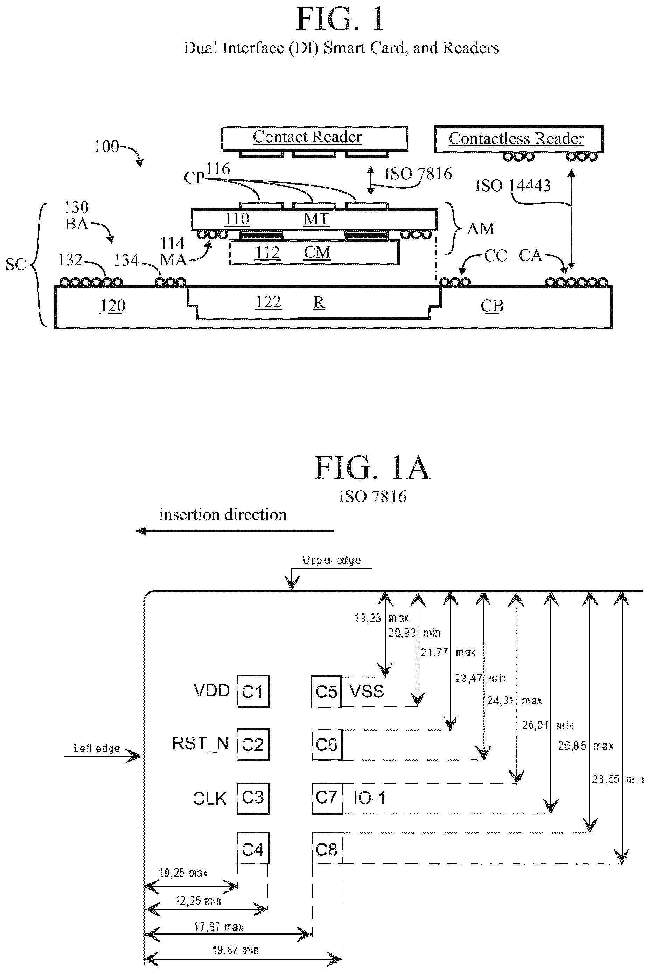

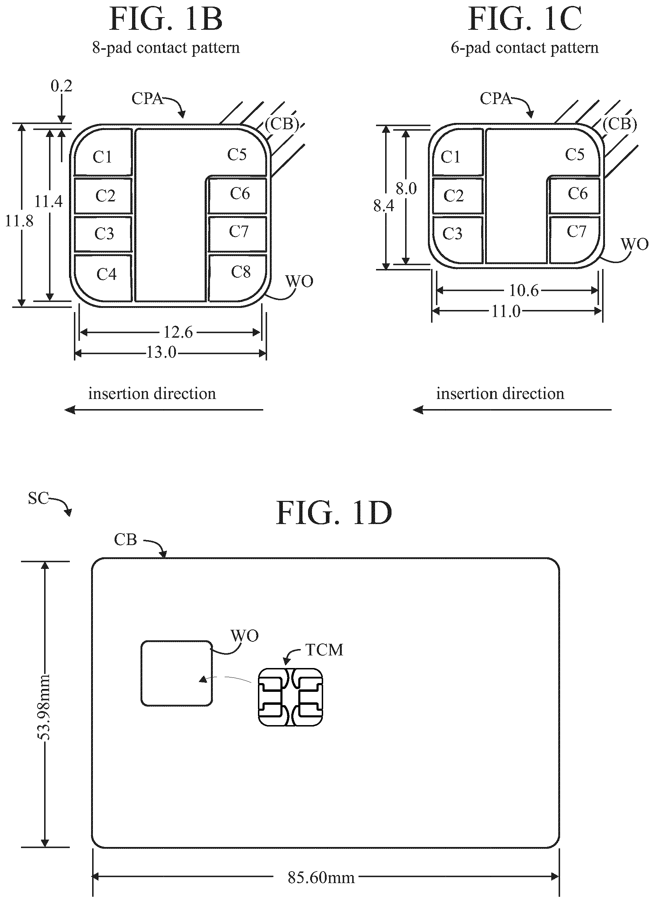

**FIG. 1** illustrates a smart card SC (100) in cross-section, along with a contact reader and a contactless reader. An antenna module (AM, or transponder chip module TCM) 110 comprises a module tape (MT) 112, an RFID chip (CM) 114 disposed on one side (face-down) of the module tape MT along with a module antenna (MA) 116 and contact pads (CP) 118 disposed on the other (face-up) side of the module tape (MT) for interfacing with an external contact reader. The card body (CB) 120 comprises a substrate which may have a recess (R) 122 extending into one side thereof for receiving the antenna module (AM). (The recess R may be stepped - such as wider at the surface of the card body (CB) - to accommodate the profile of the antenna module AM.) The booster antenna (BA) 130 may comprise turns (or traces) of wire (or other conductor) embedded in (or disposed on) the card body CB, and may comprise a number of components such as (i) a card antenna (CA) component 132 and (ii) a coupler coil (CC) component 134. It may be noted that, as a result of the recess R being stepped, a portion of the card body (CB) may extend under a portion of the antenna module (AM), more particularly under the module antenna (MA).

**FIG. 1A** shows the ISO-7816 specification for a contact pad array (CPA). Eight contact pads **C1** - **C8** are shown. The contact pads **C1 - C8** are located on the front surface of a smartcard. The dimensions are referenced to the left and upper edges of the front surface of the card. For a 6-pad layout, the contact pads **C4** and **C8** may be omitted. The signal assignments for the contact pads are,

| | | | |
|---|---|---|---|
| **C1** | VDD | **C5** | VSS |
| **C2** | RST_N | **C6** | not used |
| **C3** | CLK | **C7** | IO 1 |
| **C4** | not used | **C8** | not used |

The arrow in **FIG. 1A** ("insertion direction") indicates the direction that a smart card would be inserted into a reader, with contact pads **C1, C2, C3** and **C4** entering the reader first, followed by contact pads **C5, C6, C7** and **C8.** (A 6 pad module does not have contact pads C4 and C8.) The "insertion direction" (or "card insertion direction"), as used herein, may be defined as a direction parallel to a line drawn from **C1** to **C5,** or from **C2** to **C6,** or from **C3** to **C7** or from **C4** to **C8.** In ISO 7816, the minimum dimension for a contact pad may be 2 mm (in the insertion direction) x 1.7 mm in a direction perpendicular to the insertion direction.

**FIG. 1B** is a diagram of an exemplary contact pad array (CPA) comprising an 8-pad pattern for ISO 7816 contacts, and illustrates that an 8-pad layout may measure approximately 11.4 mm x 12.6 mm.

**FIG. 1C** is a diagram of an exemplary contact pad array (CPA) comprising a 6-pad pattern for ISO 7816 contacts, and illustrates that a 6-pad layout may measure approximately 8.0 mm x 10.6 mm.

The rectangular border extending around the various contact pad arrays shown herein (around the contact pads and the connection bridges) may represent the outer periphery of the underlying module tape (MT) as well as a similarly sized opening (WO) in a card body (CB, or inlay substrate) for the transponder chip module (TCM).
- In **FIG. 1B****,** with a 0.2 mm space around the contact pad array (CPA), the size of the opening (WO) may be approximately 11.8 mm x 13.0 mm.
- In **FIG. 1C****,** with a 0.2 mm space around the contact pad array (CPA), the size of the opening (WO) may be approximately 8.4 mm x 11.0 mm.

As is evident from **FIGs. 1B** and **1C****,** there is a relatively large space available in the center of the contact pad array (CPA) which may be devoid of contact pads (CP). This area of the contact pad array (CPA), which may be referred to as the "central area", may have the same copper foil on it as that which is used to form the contact pads (CP), and the **C5** (ground, earth) contact pad may be formed so as to extend into the central area and be contiguous with metal in the central area.

**FIG. 1D** is a diagram showing conventional dimensions of a smart card (SC) having an ID-1 format, according to ISO/IEC 7810. The card body (CB) measures 53.98 mm x 85.60 mm. A transponder chip module (TCM) is shown for insertion in the card body (CB). The transponder chip module (TCM) may be disposed in a window opening (WO) in the card body (CB). This figure illustrates the usual "form factor" for chip modules (in this case, a transponder chip module TCM), and their location in the smart card (SC).

### Connection Bridges and Through-Hole Connections

US 20130146670 (2013; Grieshofer; "Infineon") discloses a chip card contact array arrangement, comprising: a carrier; a plurality of contact arrays which are arranged on a first side of the carrier; an electrically conductive structure which is arranged on a second side of the carrier, which is arranged opposite the first side of the carrier; a first plated-through hole and a second plated-through hole; wherein the first plated-through hole is coupled to the electrically conductive structure; a connecting structure which is arranged on the first side of the carrier, wherein the connecting structure connects the first plated-through hole to the second plated-through hole; and the connecting structure having a longitudinal extent which runs parallel to a direction in which a contact-connection device on a reading device is moved relative to the plurality of contacts. See **FIGs. 3, 4B and 4C** thereof. Infineon is specific regarding the use of plated-through holes to effect connections to the connecting structure having a longitudinal extent which runs parallel to a direction in which a contact-connection device on a reading device is moved relative to the plurality of contacts.

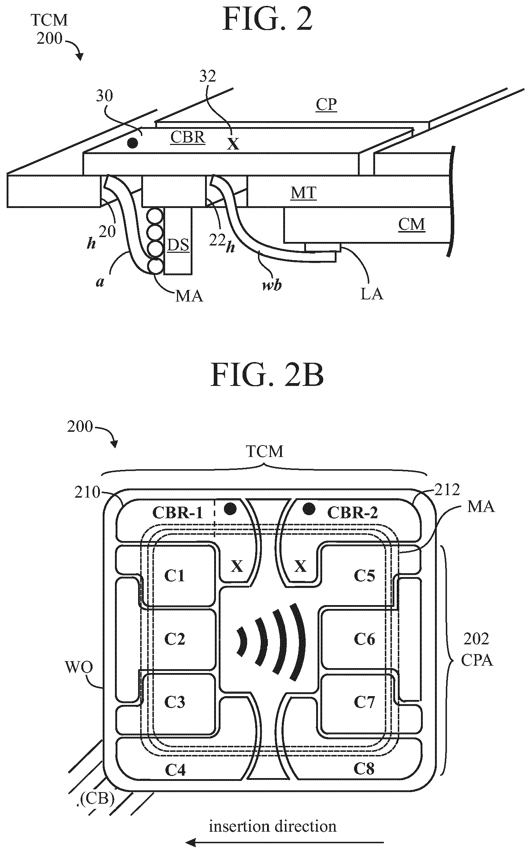

**FIG. 2** illustrates, generally, a non-claimed concept of providing a connection bridge (CBR) on the face-up (top, as viewed) side of the module tape (MT), for connecting (interconnecting) two components on the face-down (bottom, as viewed) side of the module tape (MT). The two components may be a module antenna (MA) and an RFID chip (CM, IC). Metallization on one side (front; top, as viewed) of the module tape (MT) may be patterned to have contact pads (CP, one shown) and a connection bridge (CBR, one shown). For purposes of this discussion, the module tape (MT) may be single-sided tape having metallization on only one side thereof, as illustrated. The concepts presented herein may also be applicable to double-sided tapes having metallization on both sides thereof.

**FIG. 2** shows a module antenna (MA) disposed around an RFID chip (CM, IC). The module antenna (MA) may have an outer end and an inner end, and the outer end may need to "cross over" the module antenna (MA), from outside-to-inside, to connect with the RFID chip (CM, IC). The wire-wound module antenna shown in this figure is merely illustrative. The concepts disclosed herein are appropriate for etched, planar antennas (PA). For purposes of this discussion, only one end of the module antenna (MA) and connecting it with a component such as an RFID chip is described.

In order to accomplish the "cross-over", a connection bridge (CBR) extends between a first position (dot, "•") above a first position without (external to) the module antenna (MA) to a second position ("X") above a second position within (internal to) the module antenna (MA). A first opening 20 may be provided through the module tape MT at the first position. A second opening 22 may be provided through the module tape MT at the second position.

The openings 20 and 22 may be referred to as "holes", "blind holes", "through holes" or the like, and, although they are used for making connections from one side of the module tape to the other, they are different than "plated through holes", since they are not plated.

**FIG. 2** is generally illustrative of a transponder chip module (TCM) 200. An RFID chip (CM, IC) component is provided on the face-down (bottom, as viewed) side of the module tape (MT). A module antenna (MA) component is also provided on the face-down side of the module tape (MT), on the same side of the module tape (MT) as the RFID chip (CM, IC).

The module antenna (MA) in this example comprises a wire having two ends (only one end ***a*** is shown) and may be wound on a dam structure (DS, or winding core WC). Generally, the two ends of the module antenna (MA) may need to be connected with corresponding two terminals "LA" and "LB" (only the "LA" terminal is shown in the figure) of the RFID chip (CM, IC). A module antenna (MA) wound on a dam structure is shown in FIGs. 3, 3A, 4, 4A-4F of US 20140104133**.** It should be understood that an etched planar antenna may be used instead of a wire wound antenna. In the main, hereinafter, module antennas (MA) which are planar antennas (PA) are discussed.

The dam structure (DS) may be located on the opposite side of the module tape (MT) from the connection bridge (CBR), and may be aligned under the connection bridge (CBR). The dam structure (DS) (or winding core WC) has an interior portion (to the right, as viewed) and an exterior portion (to the left, as viewed). The module antenna (MA) is wound on the exterior of the dam structure (DS). The RFID chip (CM, IC) is disposed on the module tape (MT) in the interior of the dam structure (DS). The illustrative end ***a*** of the module antenna (MA) extends external to the module antenna (MA). In the event that both of two ends (only one shown) of the module antenna (MA) extend external to the module antenna (MA), two connection bridges may be needed to make connections such as to terminals of the RFID chip.

The connection bridge (CBR) extends between a first position (dot, "**•**") above a position without (external to) the dam structure (DS) to a second position ("**X**") above a position within (internal to) the dam structure (DS). A first opening 20 may be provided through the module tape MT at the first position. A second opening 22 may be provided through the module tape MT at the second position.

The openings 20 and 22 through the module tape (MA) may be referred to as "blind holes" (or "blind vias"), and may have a diameter (or other cross-dimension) of approximately 300 µm - 500 µm to facilitate wire bonding through the blind holes in the module tape (MT). When wire-bonding through the blind holes, it may be advantageous that the conductive layer (foil, cladding) of the contact pads (CP) and connection bridge (CBR) have a thickness of approximately 35 µm, to avoid dents (dimpling). Alternatively, one connection to the connection bridge (CBR) may be made using wire bonding, and another connection to the connection bridge (CBR) may be made using plated-through holes (in the manner of Infineon, which uses two plated-through holes).
- A first portion 30 of the connection bridge (CBR) is disposed over the first opening 20. A second end portion 32 of the connection bridge (CBR) is disposed over the second opening 22.
- A first end ***a*** of the module antenna (MA) may be wire-bonded, through the first opening 20 to the underside of the first portion 30 of the connection bridge (CBR), and that a first terminal LA of the RFID chip (CM, IC) may be wire-bonded, through the second opening 22 to the underside of the second portion 32 of the connection bridge (CBR).
   -- A planar antenna may have a connection pad at its outer end which may be wire bonded through the first opening to an outer portion 30 of the connection bridge.

The connection bridge (CBR) thereby provides a conductive path which extends from a position which is above the exterior of the module antenna (MA) to a position which is above the interior of the module antenna (MA). This facilitates connecting a component (such as the module antenna MA) which is disposed external to the dam structure (DS) to a component (such as the RFID chip CM) which is disposed internal to the dam structure (DS). The connection bridge CBR facilitates making an interconnection between an outer end of the module antenna (MA) component and a terminal of the RFID chip (CM, IC) component. An outer end of an etched, planar antenna (PA) may be connected by a wirebond through opening 20 in the module tape (MT) to an outer position on the underside of the connection bridge (CBR), and a terminal of the RFID chip (CM) may be connected through the opening 22 to an inner position on the underside of the connection bridge (CBR).

Although some of the antenna structures and module antennas described herein may be disclosed as being wire-wound, there may be some applicability of the concepts disclosed in conjunction therewith to the etched, planar antennas (PA) described herein.

In contrast with the planar antenna (PA), which may have one end oriented towards its interior and one end oriented towards its exterior, a wire wound module antenna (MA, or antenna structure AS) may have (i) both of its ends oriented towards the interior of the antenna structure (AS), (ii) one end oriented towards the interior and one end oriented towards the exterior of the antenna structure (AS), or (iii) both of its ends oriented towards the exterior of the antenna structure (AS). If both ends of an antenna structure (AS) are oriented towards the exterior of the antenna structure (AS), two connection bridges may be required to effect connections to the RFID chip (CM, IC).

**FIG. 2B** shows an antenna module (AM) or transponder chip module (TCM) 200 having a contact pad array (CPA) 202 comprising of 8 contact pads (**C1-C8**). The transponder chip module (TCM) also has two connection bridges (CBR-1, CBR-2) 210, 212 on its contact (face-up) side of the module tape (MT, not shown). An RFID chip (CM, IC, not shown) and a module antenna (MA, shown in dashed lines) may be disposed on the face-down side (not visible) of the module tape (MT). A border is shown around the transponder chip module (TCM), which may represent an opening (WO) in a card body (CB, or inlay substrate) for the transponder chip module (TCM).

The connection bridges (CBR-1, CBR-2) and contact pads (**C1-C8**) may be formed from a common conductive layer or foil of copper (for example), such as on a single-sided module tape (MT) which may have a conductive layer (or foil) on its face-up side having a thickness of 35 µm. The module tape (MT) may also be double-sided, having conductive layers (foils) on both its face-up and face-down sides. Having two connection bridges (CBR-1, CBR-2) may be useful in circumstances (i) when there are two module antennas (MA-1, MA-2), or (ii) when there is a single module antenna (MA) with a center-tap, or (iii) when there is a single module antenna (MA) with both of its ends oriented outward.

The module antenna (MA) may be a planar antenna (PA) which may be an etched (chemical or laser) antenna structure (AS). Alternatively, the module antenna (MA) may be a non-planar, wire-wound antenna structure (AS). **FIG. 2** shows an example of a module antenna (MA) comprising wire wound on a dam structure (DS).

The connection bridge (CBR-1) 210 is shown disposed above the **C1** contact pad, is generally "L-shaped", and extends from an outer position (indicated by a round dot "**•**") which is without (external to) the contact pad array (CPA) and without (external to) the module antenna (MA) to an inner position (indicated by an "**X**") which is within (internal to) the contact pad array (CPA) and within (internal to) the module antenna (MA). Connections of components on the underside (face down side) of the module tape (MT) may be made to the connection bridge (CBR-1) to achieve interconnects which may otherwise require troublesome cross-overs or additional interconnect layers. Notably, in this illustration, an outer end of the module antenna (MA) on the underside of the module tape (MT) may be connected to the outer position ("**•**") of the connection bridge CBR-1, and a terminal of the RFID chip (not shown) may be connected to the inner position ("X") of the connection bridge CBR-1.

The second connection bridge (CBR-2) 212 is shown disposed above the **C5** contact pad, may be substantially a mirror image of the connection bridge (CBR-1), and may be used to effect other or additional connections (not shown or described), and will not be described further. Having two connection bridges is optional. In cases where only one connection bridge is needed, the connection bridge (CBR-2) may suffice. Either or both of the connection bridges (CBR-1, CBR-2) may be positioned below the contact pad array (CPA) rather than above it.

In the illustration of **FIG. 2B****,** the bottom contact pads **C4** and **C8** (otherwise, the bottom contact pads **C3** and **C7,** for a 6 pad array) may be shaped to resemble the connection bridges pads (CBR-1, CBR-2), for aesthetic purposes. Also, as shown herein, the contact pads **C2** and **C6** may be "T-shaped", and the neighboring contact pads **C1/C3** and **C5/C7** may have cutouts to accommodate the top of the "T", as shown, also for aesthetic purpose.

### Laser-etched Antenna Structures (LES)

US 14281876 filed 19 May 2014 (US 20140284386 published 25 Sep 2014) discloses LASER ABLATING STRUCTURES FOR ANTENNA MODULES FOR DUAL INTERFACE SMARTCARDS. Laser etching antenna structures for RFID antenna modules (AM) and combining laser etching and chemical etching are disclosed. Limiting the thickness of the contact pads (CP) to less than the skin depth (18 µm) of the conductive material (copper) used for the contact pads (CP). Multiple antenna structures (AS1, AS2) in an antenna module (AM), and incorporating LEDs into the antenna module (AM) or smartcard (SC) are also disclosed.

Generally, the transponder chip modules (TCM) disclosed herein may have a conductive (typically copper) layer for forming a planar module antenna (MA, PA) which may have a thickness greater than or almost equal to the skin depth of copper (~18 µm), for example 18 µm - 35 µm, but it could also be 12 µm. The module antenna (MA) may be directly underneath the contact pads (CP) or connection bridges (CBR).

Generally, in practice, the thickness of metal cladding (metal layer ML, conductive layer CL) on one or both sides of a single-sided or double-sided module tape (MT), respectively, which may be laser-etched to form contact pads (CP) on the face-up side of the module tape (MT), a planar antenna (PA) on the face- down side of the module tape (MT), and a coupling frame (CP) on either side of the module tape (MT) is not less than 18 µm. A coupling frame (CF), described herein below, should have a thickness greater than the electromagnetic transparency of the metal layer in question. In the case of single- or double-sided copper-clad module tape (MT), the metal layer typically has a thickness of 18 µm or 35 µm.

Laser etching is a form of laser ablation where material may be removed from a typically planar sheet (or foil) of material, and has some advantages over conventional wet etching (chemical etching). A laser etch can proceed more uniformly through the material being etched, and can also be controlled such as by increasing or decreasing the laser power and subsequent etching at various portions of a pattern being etched, in a highly-controllable manner. (With conventional wet/chemical etching, the width of the etch may be tapered, narrowing from the surface of the material being etched to the bottom of the etched feature. In contrast therewith, with laser etching, straight wall etching can be achieved whereby the sides of the feature being etched may be substantially parallel with one another.)

Using laser etching, the spaces between tracks of an antenna structure (AS, MA, PA) may be dimensionally equal to the width (kerf) of the laser beam, such as approximately 25 µm. The tracks themselves may have a width of 25 µm - 100 µm. If a coupling frame (CF) is formed from the same metal layer (ML) as the planar antenna (PA), a gap (space) between the outer track of the planar antenna (PA) and an inner edge (IE) of the coupling frame (CF) may also be equal to the width (kerf) of the laser beam, such as approximately 25 µm. After plating, the dimension of the spaces/gap may be smaller, by a few microns, such as 20 µm.

The antenna structure AS may be laser etched from a copper layer (cladding or foil), which may have a thickness less than the skin depth of copper (~18 µm), forming a number of tracks separated by a distance approximately equal to the width (or kerf) of the laser beam, such as approximately 25 µm. Subsequent to laser etching, the antenna structure may be plated, which may reduce the distance between tracks to approximately 20 µm (for example). This may result in increased performance of the antenna structure, and the overall transponder chip module (TCM), and reduce performance constraints on the performance of a booster antenna (BA) in the card body (CB) of the smartcard (SC). The track width may be less than 100 µm, and the spacing between tracks may be less than 50 µm.

The antenna structure (AS) may be formed by laser etching, having a number of (such as 10 or 12) tracks which are disposed substantially planar with one another on a module tape (MT) or other suitable substrate, in a generally rectangular spiral pattern. The spacing between tracks may be on the order of 25 µm, or less (such as 20 µm, after plating).

As described in US 14465815 filed 21 Aug 2014, (US 20140361086, published 11 Dec 2014) the track width on the laser-etched antenna structure (LES) can be varied, from end-to-end, to improve performance, in contrast with an antenna structure having a single (constant) track width. By way of analogy, this could be viewed as more than one antenna, each having a different track width, connected in series with one another. As an example, a first portion of an antenna structure may have a track width of 100 µm, another portion may have a track width of 50 µm. Additional portions may have other track widths. The spacing between tracks may also be varied. For example, the spacing between some tracks may be 25 µm or less, the spacing between some other tracks may be more than 25 µm. The ability to vary track width and spacing may be helpful in fine-tuning the performance of the module, with attendant benefits in activation distance (for example).

### Coupling Frames

As used herein, a "coupling frame" (CF) may be a planar conductive structure surrounding (disposed around) and closely adjacent to (including overlapping) a module antenna (MA) of a transponder chip module (TCM). The coupling frame (CF) has an inner edge defining an opening, an outer edge, and a slit (or slot, or gap) extending between the opening (or inner edge) and the outer edge.

US 14551376 filed 24 Nov 2014 (US 20150136858 A1**),** discloses that a coupling frame (CF) may be incorporated into an antenna module (AM) or transponder chip module (TCM), and may be formed from the same conductive layer (CL) as the contact pads (CP) on the face-up side of the module tape (MT). Alternatively, the coupling frame (CF) (or additionally, a second coupling frame) may be formed from the same conductive layer (CL) as a module antenna (MA), such as an etched planar antenna (PA), on the face-down side of the module tape (MT). Such a transponder chip module (TCM) with a coupling frame (CF) integrated therewith may be referred to herein as a "capacitive coupling enhanced" (CCE) transponder chip module (TCM).

The coupling frame (CF) may be in the form of a ring (such as a rectangular ring) having an opening (OP), an inner edge (IE) which defines the opening, and an outer edge (OE). A discontinuity which may be a slit (S) or a non-conductive stripe (NCS) may extend from the inner edge (IE) or opening (OP) to the outer edge (OE) so that the ring of the coupling frame (CF) is an open loop (discontinuous) conductor having two ends and a gap (which is the slit) there between.

### Antenna Substrates and Multiple Antenna Structures

The antenna MA may be formed of wire, embedded in the antenna substrate AS, such as shown in US 6,233,818**.** Alternatively, the antenna MA may be chemically etched from a metal layer (foil) on the antenna substrate AST. Alternatively, the antenna MA may be laser etched, which may allow for finer pitch, and more tracks. For example, the antenna may be laser etched (isolation technique) into a copper cladded "seed" layer (face-down side of the pre-preg) having a thickness of 18 µm, using a UV or Green nanosecond or picosecond laser with a distance between tracks dimensionally equal to the width (kerf) of the laser beam, approximately 25 µm. After the laser etching of the copper seed layer, the antenna substrate AS may further be processed by one or more of sand blasting to remove residual laser ablated particles and to prepare for plating adhesion; depositing carbon to support the through-hole plating of the vertical interconnects; dry film application and photo-masking process; electroless deposition copper (Cu ~ 6 µm) to increase the thickness of the tracks; electro-plating of nickel and nickel phosphorous (Ni/NiP ~ 9 µm) or nickel (Ni ~ 9 µm) and palladium/gold or gold (Pd/Au or Au - 0.1 µm/0.03 µm or 0.2 µm) to prevent oxidization.

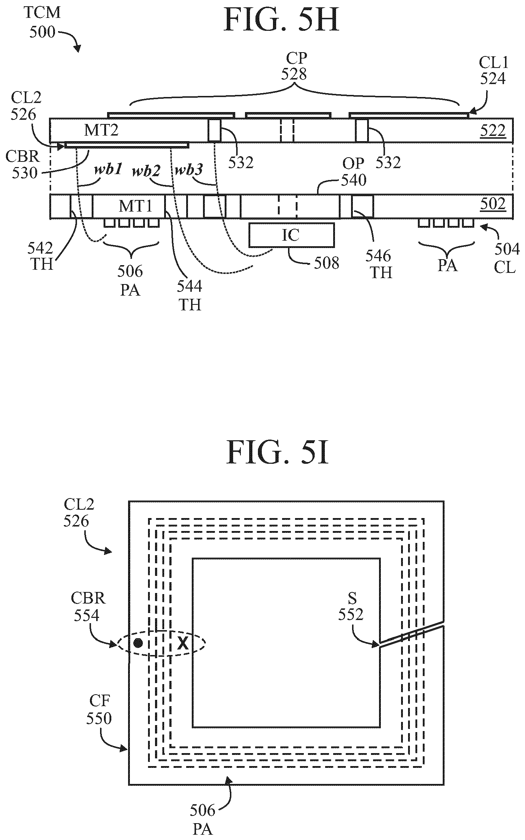

**FIG. 5H** shows a transponder chip module (TCM) 500 according to the invention comprising two module tapes (MT1, MT2). The module tapes are exemplary of any substrate having two opposite sides or surfaces. The two module tapes may be joined together, as shown (broken line).

The first module tape (MT1) or antenna substrate (AS) 502 may be single-sided copper clad, such as glass epoxy having a thickness of approximately 70 µm with a conductive (such as copper) layer (CL) 504 on the bottom side or surface (as viewed) thereof. The copper layer may have a thickness of approximately 18 µm. The copper layer CL may be patterned (such as by laser etching) to have (to be in the form of) an antenna structure (AS) or module antenna (MA) which may be a planar antenna (PA) 506 having a number (such as approximately 10 or 11) of turns. The planar antenna (PA) or antenna structure (AS), which serves as a module antenna (MA), may be chemically (wet) etched or laser etched.

The second module tape (MT2) 522 may be double-sided copper clad, such as glass epoxy having a thickness of approximately 70 µm with a conductive (such as copper) layer (CL1) 524 on the top (as viewed) side or surface thereof and a conductive (such as copper) layer (CL2) 526 on the bottom (as viewed) layer thereof. The copper layers CL1 and CL2 may both be approximately 35 µm thick. The copper layer CL1 may be patterned (such as by laser etching) to have contact pads (CP) 528. The copper layer CL2 may be patterned (such as by laser etching) to have a connection bridge (CBR) 530 and also to have bond pads (not shown). Plated through holes (PTH) 532, as an example of any conductive element, may be provided (extending) through the module tape MT2, aligned with (and in contact with) at least some of the contact pads CP, to allow for making connections from an RFID chip (IC) 508 to the contact pads CP.

Although shown on only one side (left, as viewed) of the module tape MT2, the connection bridge may extend around an outer area of the module tape MT2 in the manner of a coupling frame having a slit, such has been discussed hereinabove. (A coupling frame CF functioning as a connection bridge CBR is disclosed in US 14551376 (US 20150136858 A1)**,** at FIG. 3B thereof.) Although not shown, a coupling frame may be incorporated on the top (as viewed) side of the module tape MT1.

**FIG. 5I** shows the conductive layer (CL2) 526 patterned to have a coupling frame (CF) 550 having a slit (S) 552. A portion 554 of the coupling frame serves as a connection bridge, making a connection from an outer portion (indicated by the dot "•"), to an inner portion (indicated by the "x") thereof, such as was discussed with respect to **FIGs. 2** and **2B****.**

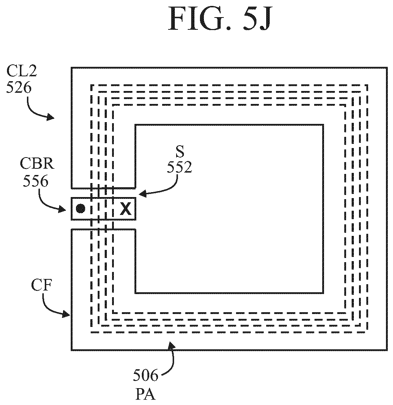

**FIG. 5J** shows that the conductive layer (CL2) 526 may be patterned to have a coupling frame (CF) 550 with a slit (S) 552 which is wide enough (such as approximately 500µm - 1mm wide) to accommodate a connection bridge (CBR) 556 in the slit. The coupling frame may extend beyond the boundaries of the contact pads 528 and the antenna 506 (such as shown in **FIG. 5H**).

An opening (OP) 540 extending through the module tape MT1 allows placement (mounting) of the RFID chip (IC) 508 onto the second module tape (MT2).

A number of through holes (TH) may be provided (extending) through the module tape (or antenna substrate) MT1 to allow for wire bonds to be made to the connection bridge CBR and the plated through holes 532. A through hole 542 is aligned with an outer portion of the connection bridge, and a wire bond connection ***wb1*** may be made through the through hole 542 from an outer end of the antenna to the outer portion of the connection bridge. A through hole 544 is aligned with an inner portion of the connection bridge, and a wire bond connection ***wb2*** may be made through the through hole 544 from an inner portion of the connection bridge to the RFID chip. Additional through holes 546, aligned with the plated through holes 532, allow for wire bond connecting the RFID chip (IC) to the plated through holes (PTH) in the module tape (MT2), hence connecting with the contact pads (CP) on the module tape (MT2). Only some of the additional through holes (546) and one of the wire bonds ***wb3*** passing therethrough are shown, for illustrative clarity.

### Through-Hole Connections

Traditional through-hole plating of double sided tape to connect a top metal layer to a bottom metal layer can be replaced by a technique of mechanical pinching, pressing or laminating a metal layer at a position on a tape where a through-hole had previously been punched, drilled or lased and then fusing the pinched, formed or indented metal layer by a process of lasing or welding with an opposing metal layer, before electroplating. The module tape (MT) can therefore accommodate a combination of vertical interconnects and blind vias.

The substrate may be a module tape (MT) or chip carrier tape (CCT) of an antenna module (AM) or transponder chip module (TCM), as examples of RFID devices generally.

The transponder chip module (TCM) is a dual-interface module having contact and contactless interfaces.

Generally, through hole connections (THC) may be made from a portion of a conductive layer (CL) on one side of the substrate (MT) to a conductive layer (CL) on the other side of the substrate. The conductive layers (CL) may comprise a conductive foil, such as copper, laminated with an adhesive to the relevant side of the substrate (MT). Generally, the substrate (MT) may be prepared with at least one opening, or "through hole opening" (THO), extending through the substrate (MT), and at least one of the conductive layers (CL) spanning the opening (THO) may be deformed such as by pinching, punching, or pressing to make contact with the conductive layer (CL) on the other side of the substrate (MT), after which the conductive layers may be welded together, such as by laser welding, spot welding, ultrasonic welding, or any suitable process for joining the two conductive layers together within the through hole opening (THO).

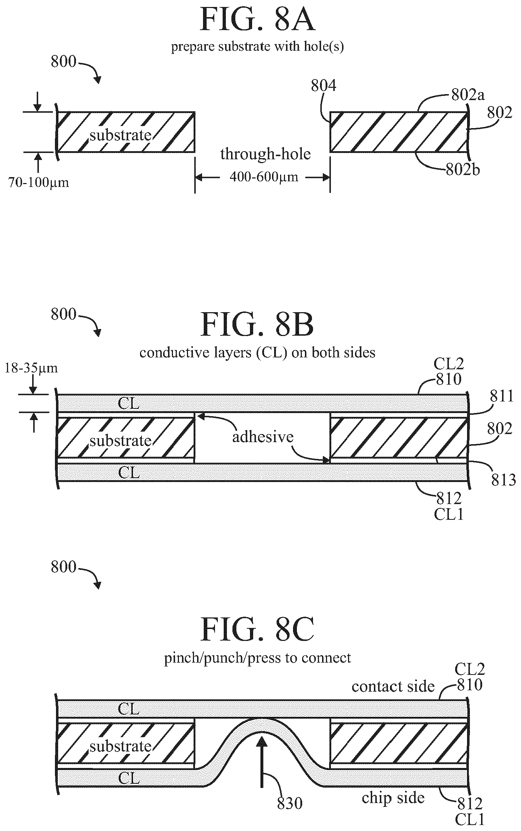

**FIGs. 8A, 8B, 8C** are diagrams illustrating a method of making connections through a substrate.

**FIG. 8A** shows a substrate which may be an epoxy-glass module tape (MT) 802 such as may be used in a transponder chip module (TCM) 800. The substrate may have a top side 802a, a bottom side 802b, and a thickness of approximately 70 µm - 100 µm. A process for making connections through the substrate will be described in a series of steps, presented in an exemplary order. It should be understood that some steps could be performed in another order than that which is described.

In a first step, the substrate may be prepared with one or more openings 804, which may be referred to as through hole openings (THO, or simply "holes", or "through-holes"), whereat it is desired to make a connection from a component (or interconnect trace) on one side of the substrate to a component (or interconnect trace) on the other side of the substrate.

The holes may have cross-dimensions of approximately 400 µm-600 µm, and may be formed by punching, drilling or laser ablation, or any other suitable process. This is similar to what was shown in **FIG. 2****,** above, wherein "blind holes" having a cross-dimension of approximately 300 µm - 500 µm are formed through a module tape (MT) to facilitate wire bonding through the blind holes in the module tape (MT).

**FIG. 8B** shows conductive layers (CL) 810, 812 disposed on the top and bottom sides 802a and 802b, respectively, of the substrate 802. A given conductive layer may comprise a copper foil having a thickness of approximately 18 µm - 35 µm, and may be secured to the respective surface of the substrate using an adhesive 811, 813, respectively. The adhesive may have a thickness of approximately 20 µm, and may be applied in a manner that it does not invade (enter) the through-hole, although it may be acceptable that some adhesive enters the through-hole. A suitable adhesive may be polyurethane.

The conductive layer (CL2) 810 shown in **FIG. 8B** disposed atop the substrate, such as on the "face-up" side thereof, may be patterned such as by laser etching to comprise contact pads (CP) in a contact pad array (CPA), or connection bridges (CBR), a planar antenna (PA) or any other isolated conductive feature which may be relevant to transponder chip modules (TCM).

The conductive layer (CL1) 812 shown in **FIG. 8B** disposed below the substrate, such as on the "face-down" side thereof, may be patterned such as by laser etching to comprise interconnect traces (IT) a planar antenna (PA) or any other isolated conductive feature which may be relevant to transponder chip modules (TCM).

**FIG. 8C** shows that the conductive layer (CL1) 812 on one side of the substrate - in this example, the lower conductive layer on the bottom, face-down side of the substrate - is deformed (indented) using any suitable, typically mechanical technique of pinching, pressing or laminating so that a portion of the lower conductive layer 812 which is aligned with the through-hole 804 deforms sufficiently to come into contact with the portion of the upper conductive layer (CL2) 810 aligned with the through-hole on the opposite side of the substrate. In other words, a portion of a conductive layer which spans (extends over) the through-hole on one side of the substrate may be deformed so as to extend through the through-hole and at least to the opposite surface of the substrate whereat it may contact and be joined with a conductive layer on the opposite side of the substrate.

Alternatively, rather than simply deforming the conductive layer on the bottom, face-down side of the substrate, it may first be cut or slit at the location of the through-hole, then portions of the conductive layer spanning the through-hole may be bent to come into contact with the conductive layer on the top, face-up side of the substrate.

Finally, a process of lasing or welding 830 may be employed to fuse the conductive layers together in the through-hole. A green laser (532 nm) may be used for welding the two conductive layers together. The resulting structure may be electroplated. The module tape (MT) can therefore accommodate a combination of vertical interconnects and blind vias.

For making a plurality of connections through a substrate (in the context of a connection bridge CBR, typically two connections through the substrate may need to be made), the process described herein may be used in conjunction with the process described hereinabove (wire-bonding through the module tape), resulting in different types of connections being made through a given substrate. A module tape (MT) for a transponder chip module (TCM) can therefore accommodate a combination of vertical interconnects and blind vias.

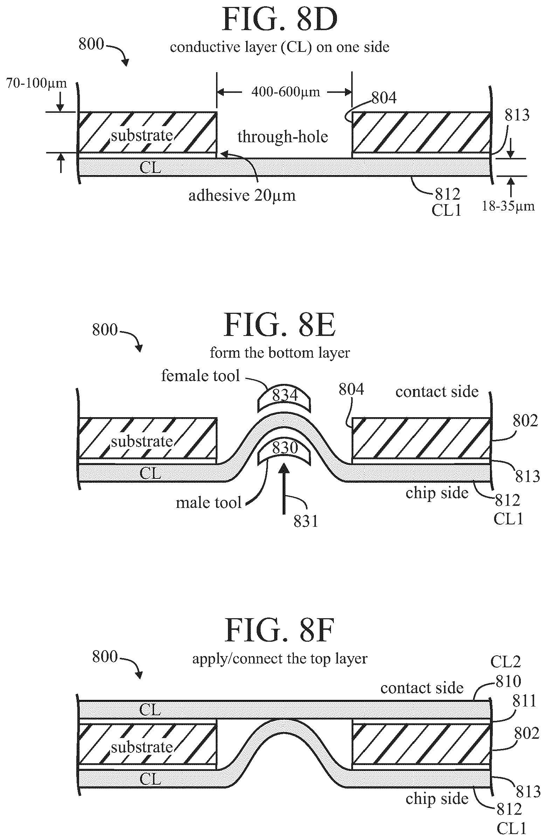

**FIGs. 8D, 8E, 8F** illustrate an alternative method of making connections through a substrate 800. This technique shares some steps with the previously-described technique, and the materials and processes may generally be the same as were described with respect to the previously-described technique.

**FIG. 8D** illustrates a first step wherein a substrate 802 such as "bare" (no cladding) glass-epoxy tape is punched to have through-holes 804, and thereafter a conductive layer 812 is disposed on only one (shown at the bottom) side thereof. For example, a copper foil could also be laminated to the glass epoxy, such as in copper cladding. For example, the conductive layer may be disposed on the face-down side of the substrate and may be patterned to exhibit a planar antenna (PA), a coupling frame (CF), interconnect traces (IT), or any other desired isolated conductive structure appropriate for the face-down side (for example) of a transponder chip module (TCM).

The conductive layer may then be patterned to exhibit contact pads (CP), connection bridges (CBR), a planar antenna (PA), a coupling frame (CF), interconnect traces (IT), or any other desired isolated conductive structure appropriate for the face-up side (for example) of a transponder chip module (TCM).

Alternatively, a substrate which is a single-sided epoxy glass tape already having a conductive layer already disposed on one side thereof may be prepared with holes extending through the tape to expose the underside of the conductive layer. A UV laser may be suitable for creating the through-holes through the substrate, terminating at and exposing the conductive layer.

**FIG. 8E** illustrates a next step, wherein the conductive layer (such as copper foil) is pinched, punched or pressed at the position of the through-hole so that it is deformed (has deformities such as bumps or hillocks, projecting upward, towards the opposite side of the substrate) to extend at least to the other surface of the substrate, and possibly a few microns (µm) beyond. This may be done using a male tool 832 and a female tool 834 (or anvil, or die). The male tool may move against a non-movable female tool, or the female tool may also move against the male tool. In this manner, the shape (form) of the stretched copper may be better controlled, and the surface of the conductive layer extending through the through-hole may be patterned to have a non-smooth topography for better connecting with the conductive layer subsequently applied (to the top of the substrate, in the next step).

Alternatively, a foil for the first conductive layer on the bottom (face-down) side of the module tape (see **FIG. 8D**) may first be prepared or formed (deformed) with projections (bumps, hillocks), then later applied to the substrate tape, but aligning a plurality of bumps with a corresponding plurality of through-holes may present some alignment problems. Alternatively, rather than deforming the foil to have projections, projections of a conductive material (such as solder balls or bumps) may be applied to a surface of the foil which is then joined with a substrate prepared with through-holes.

**FIG. 8F** illustrates a next step, wherein a second conductive layer 810 is disposed on the opposite (in this example, top, or face-up) side of the substrate (module tape MT). The conductive layer may be joined to the substrate using an adhesive 811. This conductive layer may be patterned to exhibit contact pads (CP), connection bridges (CBR), and optionally a planar antenna (PA), a coupling frame (CF), interconnect traces (IT), or any other desired isolated conductive structure appropriate for the face-up side (for example) of a transponder chip module (TCM).

Finally, the two conductive layers may be intimately connected (mechanically and electrically) with one another using any suitable technique such as resistance welding, ultrasonic bonding or laser welding 830.

The connecting techniques disclosed in **FIGs. 8A-F** may be applied to any of the transponder chip modules disclosed herein.

### Laser-etched Process with Through-Hole Connections

A process steps to produce Flexible Laser-etched Circuits (FLEC) with Through-Hole Connections (THCs) for Contactless and Dual Interface Modules used in Identification and Secure Transaction Applications may be performed with the following sequence of steps:
0) 150 mm wide rolls of glass epoxy tape with no copper cladding on either side (glass epoxy, thickness 70 or 110 µm) is the raw material input to the production process. The surface of the glass epoxy tape may be sandblasted before application of adhesive layers.
1) A one component polyamide thermoplastic adhesive may be roll deposited onto one side of the glass epoxy tape having a layer thickness of approx. 20 µm. A release liner having a thickness of 25 µm may be used to protect the adhesive layer from dust and particles in the environment. In a next step, a second adhesive layer may be deposited onto the opposite side of the glass epoxy tape and protected by a release liner.
2) In a next step, index hole(s), two outer sprocket holes and through holes (Ø 300 - 600 µm) may be punched across the 150 mm tape, through the now double sided adhesive coated glass epoxy tape.
3) In a next step, an electrodeposited copper foil (12 µm, 18 µm or 35 µm in thickness) having a width of 140 mm may be roll laminated to an adhesive coated side of the glass epoxy tape, covering the previously punched holes creating a single sided copper laminated glass epoxy tape having a peel strength greater than 10 N/cm. The index hole(s) and sprocket holes are not covered by the copper foil.
4) In a next step, the exposed copper covering each of the though-holes in the glass epoxy tape may be formed by a punch and press tool, so that the copper is stretched around the walls of the through-holes (pushed into the through-holes) and extends substantially to (so as to be flush with), including extending slightly beyond the opposite side of the glass epoxy tape. Portions of the copper which are deformed, stretched and extending into the through-holes may be analogised to "rivets".
5) In a next step, a second copper foil (12 µm, 18 µm or 35 µm in thickness) may be roll laminated to the other adhesive coated side of the glass epoxy tape, covering the holes with the formed or riveted copper.
6) In a next step, to create through-hole connections (THCs), the riveted copper is fused with the opposing copper layer at each through-hole position on the tape.
7) In a next step, the remaining 8 sprocket holes are punched into the 140 mm wide double sided tape using the previously punched sprocket holes on each side of the 150 mm tape for alignment. This means there is copper covering the through-hole connections (THCs) and there are punched-through index hole(s) and 10 sprocket holes across the 150 mm tape.
8) In a final step before degreasing, cleaning and plating, the features on the face-up side (contact pads, connection bridges) and face-down side may be laser-etched. (Alternatives to laser etching - namely stamping a metal foil - to form the contact pads and connection bridges are disclosed herein.)

### A Construction for a Transponder Chip Module (TCM)

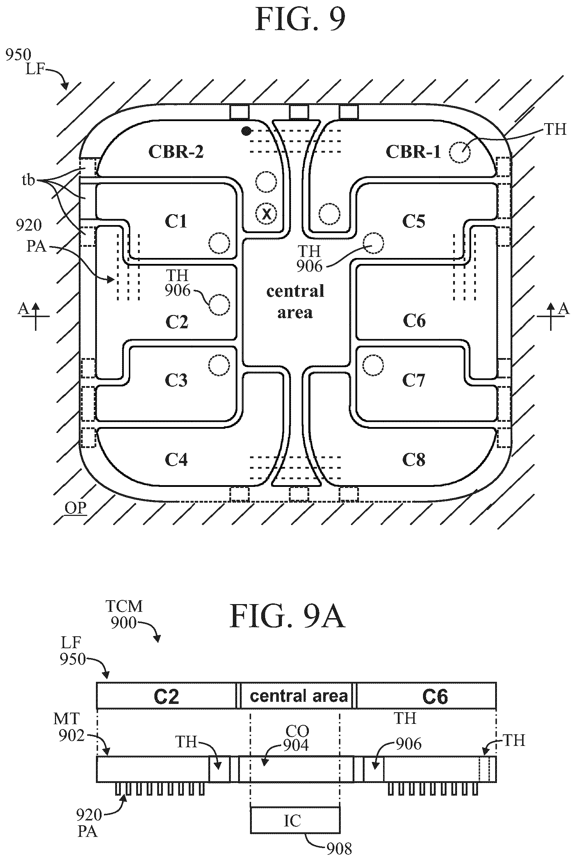

**FIGs. 9, 9A** show an example of a construction for a transponder chip module (TCM) 900. Generally, an antenna substrate (AS) comprising a module substrate (MS) 902 such as an epoxy-glass module tape (MT) having a planar antenna (PA; or module antenna MT) formed on one side thereof may be joined to an etched or stamped metal sheet, or layer (or tape, (or foil), which may be referred to as a leadframe (LF) 950. An RFID chip (IC) 908 may be provided. Some steps for making the transponder chip module (TCM) 900 and its various components may be described in an exemplary illustrative order. It should be understood that some steps could be performed in another order than that which is described.

Many kinds of integrated circuit packaging are made by placing a silicon chip on a lead frame, then wire bonding the chip to the metal leads of that lead frame. Although the stamped metal tape disclosed herein does not match that definition exactly, it may nevertheless be referred to as a "leadframe" since it can be manufactured using conventional leadframe techniques.

**FIG. 9** shows a stamped metal layer or sheet (or tape), which may be referred to herein as a leadframe (LF), having a plurality of isolated conductive features such as an arrangement of contact pads (CP, C1 - C8) and connection bridges (CBR-1, CBR-2). Small, generally rectangular tie-bars (***tb***) are shown extending from peripheral portions of the isolated conductive features to an outer portion (OP) or frame of the leadframe (LF), for supporting the arrangement of contact pads and connection bridges, and may also be useful for subsequent electroplating of the isolated conductive features. The tiebars may be approximately 800µm long, along a gap between the outer portion (OP) of the leadframe and external edges of the isolated conductive features. (The outer portion OP of the leadframe is shown with diagonal lines / shading.) A central area of the leadframe may be contiguous with the **C5** contact pad, which may be "ground". In the final product, the tie-bars ***tb*** and outer portion OP of the leadframe will be removed (excised), such as by punching.

The metal connection bridges and ISO 7816-2 contact pads can be fabricated by laser or chemical etching of electrodeposited copper (followed by metal passivation coatings) or by stamping for example 70 µm thick copper foil, or a similar metal or metal alloy and laminating the stamped foil to the module substrate (module tape). Additional narrow tracks (or tabs, or tie-bars) may be provided to link one or more of the (isolated conductive features) to the periphery of the module for mechanically supporting the isolated conductive features, and may also facilitate an electroplating or stamping processes. One or more of these tie-bars can remain in the final module or can be removed during production of the module tape by laser etching, chemical etching or punching.

After the leadframe is mounted to a module tape and the tie-bars are cut, the outer portion of the leadframe may be discarded, leaving only the inner portion having contact side metallization (CSM) on the module tape.

**FIG. 9** shows, partially, in dashed lines, the planar antenna (PA) 920, which is not part of the leadframe (LF), to illustrate its position relative to the isolated conductive features. **FIG. 9** also shows, as small circles, some through-holes (TH), described hereinbelow, which are not part of the leadframe (LF), to illustrate their positions relative to the isolated conductive features. Generally, a through hole will be located underneath an isolated conductive feature such as a bond pad which needs to be connected with the RFID chip or antenna on the other side of the module tape.

**FIG. 9A** shows the leadframe (LF) in cross-section, being assembled (laminated) to the top (face-up) side of a module tape (MT) 902. The module tape may be an epoxy-glass substrate having a thickness of approximately 100µm. The module tape may have a planar antenna 920 on its bottom (face-down) side. The module tape may have a central opening (CO) 904 so that an RFID chip (IC) may be mounted to a central area of the leadframe, through the central opening in the module tape. The module tape may have a number of through holes (TH) 906 so that the RFID chip may be connected, by wire bonds extending through the through holes, to undersides of selected ones of the contact pads on the leadframe.

In a first step, a module tape (MT) (or substrate) may be prepared with a number of through-holes (TH), aligned with at least some of the contact pads (CP) and connection bridges (CBR) for allowing through-hole connections to be made between components (such as module antenna MA; and RFID chip IC) on the face-down side of the module tape and the isolated conductive features on the face-up side of the module tape. These through-holes, shown as small circles in **FIG. 9** (the through-holes are in the module tape, not the leadframe) may have a cross-dimension (such as diameter) of approximately 100's of microns, up to approximately 1mm (1000µm). Only the through-holes along the section line A-A are visible in **FIG. 9****.** A larger opening (CO) may be provided through the module tape (MT), for allowing an RFID chip (IC) to be mounted, "recessed" through the module tape, to the underside of the central area of the leadframe (LF), rather than to the bottom surface of the module tape, if desired.

In a next step, copper foil (or cladding), having a thickness of approximately 18µm, or 35µm, may be joined (clad, cladded, laminated) to the face-down side of the module tape (MT) and etched (such as with laser-etching) to form a planar antenna (PA) having a number of turns (tracks, separated by spaces). The module tape (MT) with planar antenna (PA) may be considered to be an antenna substrate (AS). Single-sided epoxy-glass tape with copper cladding on one side thereof may be used. Double-sided tape is not necessary for this example.

In a next step, bond pads may be added to the module tape (MT). The bond pads may comprise little segments/pieces of ribbon tape, forming ribbon patches or bond pads suitable for accepting wire bonding. For example, a bond pad may be provided for connecting to the outer end of the module antenna, and another bond pad may be provided within the interior area of the module antenna for connecting to the appropriate terminal of the RFID chip (IC).

In a next step, the antenna substrate (AS) may be joined (assembled), such as by laminating, to the underside of the leadframe (LF) and interconnected therewith.

A central opening (CO) may be formed in the module tape (MT) so that the RFID chip (IC) 908 may be mounted to the leadframe (LF) rather than being mounted on the module tape (MT). The RFID chip would typically be mounted to the leadframe after the module tape is joined to the leadframe. The leadframe may have a thickness of approximately 70µm. The RFID chip may have a thickness of approximately 150µm. Wire bonds extending from the RFID chip (such as through the through holes for connecting with the undersides of contact pads) may have a loop height of approximately 100µm. Epoxy encapsulating the RFID chip and wire bonds may have a thickness of 50µm, over the wire bonds.

The RFID chip may be connected with the contact pads and connection bridges by through-hole connecting, as described herein, by wire bonding through holes extending through the module tape to the undersides of the contact pads (and connection bridges). Alternatively, additional bond pads, interconnects and through-hole connections (such as through-hole plating) may be provided for connecting the RFID chip with the module antenna, contact pads and/or connection bridges.

Techniques for manufacturing transponder chip modules (TCM) for application in dual interface smartcards having two communication interfaces (contact and contactless) may generally comprise one or more of the following steps:
- prepare laser-etched antennas on an antenna substrate, which may be single sided copper clad glass epoxy tape with punched holes or openings;
- prepare a plated metal frame having a stamped contact pad layout, and optionally connection bridges;
- join (or adhesively attach) the antennas to corresponding contact pad arrangements on the metal frame to form transponder sites;
- mount dual-interface chips at the transponder sites; and
- make appropriate inter-connections between the dual-interface chips and the underside of the contact pads (and connection bridges) on the metal frame as well as connections to the antennas.

The laser-etched antenna may have several tracks (or turns, of one long spiral track or trace) spaced 25µm from one another, and may be plated, such as with nickel and (or nickel/gold). Subsequent plating may reduce the spacing between the tracks of the antenna, thereby increasing inductance/capacitance of the antenna structure and improving performance of the antenna module.

The glass epoxy tape may have a thickness of approximately 100µm. Alternate materials for the tape may include materials such as Pyraluxor Kapton B (polyimide). Some tapes may already be prepared with a conductive layer (e.g., of copper). Other tapes may require the addition of a copper layer. The copper layer may be an electrodeposited (ED) copper layer. ED copper layers are amenable to laser etching (ablation). The copper layer may have a thickness of approximately 18µm or 35µm. The polyimide layer made have a thickness of approximately 25 µm. The stamped metal frame may be made of roll annealed copper selectively plated with nickel or nickel/gold with a thickness in the range of 70 µm.

The techniques described herein are applicable to the use of a laser etched antenna structure with a stamped leadframe. The stamped leadframe is used to form the contact pads (including CBRs) from typically 70 µm thick copper. The contact pad gap and leadframe feature sizes may be chosen to be suitable for stamping, in the range 150 - 300 µm for example. This leadframe is then laminated, using adhesive, to the glass epoxy substrate. The glass epoxy substrate may be a single sided copper clad laminate, bearing our usual laser or chemically etched antenna structure.

The stamped leadframe may be spot plated with nickel/palladium, nickel/gold or nickel/ palladium/gold to permit gold wire bonding of the RFID chip IC. The connections to the RFID chip IC may be made using blind vias (as described hereinabove).

**FIG. 9** shows that there may be two connection bridges (CBR-1, CBR-2) disposed above the array of contact pads (C1 - C8). One CBR (CBR-1) may be used to bring the outer antenna connection (dot, "•") inwards (past the intervening turns of the module antenna) to the position "**x**" to connect with the RFID chip. However, instead of a gold wire bond or plated through hole, the connection may be made by a thermocompression bond (or similar). The second CBR (CBR-2) may be used to link the innermost antenna winding to the IC. The IC is wire-bonded through a blind via to the CBR. The antenna may be thermocompression bonded (or similar) to the same CBR using a second blind via.

The use of thermocompression bonding (or similar) to make the antenna connections has the advantage that the laser etched antenna structure need not necessarily be electroplated with nickel/gold passivation layers, or spot plated at the connection sites. This reduces the cost of and simplifies the manufacturing process. The bond areas may be cleaned or roughened using a laser to improve the quality of the thermocompression bond. Alternatively, a copper or aluminum (aluminium) wire bond may be used. In order to prevent oxidation of the laser etched antenna structure during device use the module may be completely or selectively coated with a spray cast conformal coating, a UV cured epoxy or other protective film.

### Stamped Leadframe Design

The stamped leadframe may comprise a 70µm thick sheet or layer of copper (metal foil). Various isolated conductive features may be formed in the foil by a stamping process, separated from one another be slits and connected with one another by tie-bars which will eventually be excised. The feature sizes may be limited by the stamping (punching) tool. For volume production the smallest feature size may be 200µm.

The design uses tie-bars to link the contact pads together and to the leadframe. After lamination of the leadframe to the glass epoxy these tie-bars may be disconnected by laser etching or by a punching tool to electrically isolate the features, which may be referred to as "isolated conductive features" such as contact pads and connection bridges, and additional isolated conductive features (discussed below). The shape of the contact pads (and connection bridges) may be established to accommodate the spot plating positions and larger vias. The various isolated conductive features (sans tie-bars) may be referred to as "contact side metallization" (CSM).

The connections of the chip IC to the antenna may be made with ribbon tape bond pads. The leadframe may be spot plated with nickel, palladium and gold to facilitate wirebond or other connections. The connection of LA and LB on the chip side to the antenna terminals may be interchanged. There are a number of methods to achieve the connection, for example:
1. Use of spot plating on the terminals of the antenna. For the outer antenna connection at CBR-1 a gold wirebond may be used. A gold wirebond links the chip LB to CBR 1. The inner connection may be made by direct connection of the chip IC to the antenna end.
2. Use of a ribbon tape connection (or thermocompression bond), welded to the antenna terminals and to the CBRs. This employs the use of CBR-2 bearing two spot-plated positions. One spot is used for the ribbon tape or wire weld, the second may be directly wire bonded to the chip. The outer antenna connection is brought inwards by CBR-1, the inner connection is bridged by CBR-2.
3. A ribbon tape contact may be used differently. Rather than being connected directly to the antenna and the spot plating on the stamped leadframe, the ribbon may be only bonded to the terminals of the antenna. In this case the ribbon may have a surface finish such as a stack of nickel/palladium/gold that permits wire bonding. In this case, the ribbon tape may be welded to the antenna terminal positions and a gold wirebond used to make the connection to both CBRs (CBR-1, CBR-2). This means the ribbon tape becomes an alternative to spot plating of the antenna terminals. In addition, the ribbon tape may be placed prior to laser ablation of the module (planar) antenna.

One further note is that some of the drawings show bulk removal of the copper on the bonding side, this is for clarity. Rather than performing bulk removal, the copper inside the area of the antenna may be left in place, and segmented, such as either using cross-hatch patterns or straight lines cut with the laser.

The leadframe techniques (stamping a metal sheet) disclosed herein with respect to **FIGs. 9, 9A** may be applicable to the contact side metallization of other ones of the transponder chip modules disclosed herein, it being understood that some of the contact side metallizations are specifically described as being formed by etching a conductive layer.

### Laser Imaging

US 14281876 filed 19 May 2014, (US 20140284386 25 Sep 2014) discloses LASER ABLATING STRUCTURES FOR ANTENNA MODULES FOR DUAL INTERFACE SMARTCARDS. An exemplary method of forming an antenna structure (AS) for an RFID antenna module (AM) disclosed therein may comprise:
performing a first etch to etch at least partially through a conductive foil to exhibit tracks separated by spaces, the spaces being the etched portions of the foil, the tracks being the unetched portions of the foil; and
mounting the foil to a module tape (MT);
wherein the first etch comprises laser ablation.

An alternative process to laser ablation of electrodeposited metal foils in flexible circuits is known as Laser Direct Patterning (LDP). This process is used to develop features with 10 micron resolution and is compatible with several metal types on a range of common polymer substrates including PET, polyimide, PEN, PMMA or equivalent branded substrates such as Kapton^{®}, Upilex^{®}, Kaladex^{®}, Melinex^{®} and Mylar^{®}. The first step in the process is vapor deposition of a thin metal layer (< 150 nm) on the polymer substrate. Next, a UV excimer laser (e.g. 308 nm wavelength) projects a photomask pattern onto the metal surface. A high energy pulse delivering, for example, 1050 mJ at a repetition rate of 300 Hz can be used to expose an area up to 400 mm² with a single laser pulse (Coherent). Because the metal is very thin, with weak UV absorption, the incident laser beam passes through it to the substrate. Most organic substrates, such as those listed above, will have strong UV absorption resulting in ablation of the uppermost layer of the polymer and, co-incidentally, removal of the metal layer (e.g. copper). In this manner, a set of features or tracks, e.g. antenna tracks, may be defined. A reel-to-reel process may be designed such that the reel moves continuously with respect to the laser imaging station, the motion of the substrate being frozen by the short 30 ns pulse duration. Subsequent electroless or electroplated deposition of metal can be used to increase the metal thickness and add passivation and/or finishing metal layers.

In a variation of this process, a photomask may be omitted entirely with direct laser patterning of the thin metal coating on the substrate. In this case a laser spot scans or rasters the substrate to remove metallized areas and reveal the final pattern. In this manner, very small features can be defined (< 200 nm) with the feature size ultimately limited by the minimum size of focused laser spot achievable.

Another alternative process to laser ablation of electrodeposited metal foils in flexible circuits is known as Laser Direct Imaging (LDI). This is a variation of traditional chemical etch processing. In LDI a laser is used to image a pattern directly onto a photoresist-coated panel, eliminating the production and use of a traditional photo tool. As per laser ablation LDI enables the size, orientation and shape of the written pattern to be varied as needed. A resist film designed for LDI (e.g. DuPont^{®} Riston^{®} LaserSeries) may be laminated or otherwise deposited onto a metal or metal-coated substrate. The resist is then exposed to the laser beam and cured. Subsequent development of the resist reveals the exposed pattern, following this step normal chemical etching and plating procedures can be used. Typical commercial LDI systems can produce 25 micron minimum feature size (Coherent) though feature sizes as small as 12 micron have been reported in new systems (Orbotech Paragon^{™}-Ultra 100).

These techniques, and variations thereof, may be used to create antenna structures for transponder chip modules.
- The planar antenna (PA) described herein may be a laser-etched antenna structure (LES) on the face-down side of a module tape (MT) or chip carrier tape (CCT). Elements of the laser-etched antenna structure (LES) may reside on the face-up side of the transponder chip module (TCM). The laser-etched antenna may consist of multiple coil structures to regulate the electrical parameters of resistance, capacitance and inductance. Other types of structures and features may also be arranged or formed on either side of the transponder chip module (TCM) such as through the process of chemical etching. The teachings disclosed herein with reference to a laser-etched antenna structure (LES) may equally apply to a chemical-etched antenna structure (CES) provided the reduced spacing between antenna tracks obtained by laser etching can be accomplished in a chemical etch process. Such critical dimension in spacing between tracks may be less than 100µm, 75µm, 50µm or 25µm. In addition, track widths may be less than 100µm, 75µm or 50µm.
- The planar antenna (PA) may be indirectly connected to the chip (CM) through connection bridge(s) and plated through-holes; connection bridge(s) and fused metal layers (such as described with respect to **FIGs. 8A-C****,** **D-F**); and blind vertical interconnect(s) using wire bond(s) to make the physical electrical connection. Some of the interconnections to the chip (CM) may be directly connected to bond pads (BP) on the chip (CM).
- The planar antenna (PA) is arranged, formed or mounted on a separate antenna substrate and aligned to the module tape (MT) or chip carrier tape (CCT) using index holes and or sprocket holes. The antenna substrate made of a suitable material (e.g. single or double sided copper clad glass epoxy tape or metallized foil) may be adhesively attached or laminated to the module tape (MT) with blind openings or fused metal layers to facilitate interconnections to and from the module tape (MT) to the antenna substrate. The antenna structures (AS) on the antenna substrate may be formed or arranged on one or both sides of the substrate.
- Transponder chip modules (TCM) may consist of several component elements, such components may comprise of a laser ablated antenna or antennas on a flexible or rigid substrate hereinafter called an antenna substrate which is later attached or mounted to the module tape (MT). Such antenna substrate may have an opening or window to accept a chip (CM) and holes to allow for wire bonds to be connected through the substrate to the underside of the module tape. The laser ablated antenna may comprise of a single coil structure having a given number of turns (e.g. 10) with spacing between antenna tracks equal to or greater than the width (kerf) of a laser beam (e.g. 25 µm). The antenna may have a full number of turns or portions thereof, a quarter, half or three quarter turn at its end for the purpose of tuning the resonance frequency. The antenna may comprise of a dual antenna structure (AS) with the outer winding of the first antenna connected to the inner winding of the second antenna. The spacing between tracks for each antenna structure (AS) may differ to enhance the overall capacitance or to introduce a double bell shape curve around the resonance frequency of the transponder to capture the upper and lower side lobes. The antenna substrate may have antenna structures (AS) on both sides of the substrate. The width of the antenna tracks may also vary.
- The track width of the antenna can be varied, from end-to-end, to improve performance, in contrast with an antenna having a single (constant) track width. By way of analogy, this could be viewed as more than one antenna, each having a different track width, connected in series with one another. As an example, a first portion of an antenna structure (AS) may have a track width of 100 µm, another portion may have a track width of 50 µm. Additional portions may have other track widths. The spacing between tracks may also be varied. For example, the spacing between some tracks may be 25 µm or less, the spacing between some other tracks may be more than 25 µm. The ability to vary track width and spacing may be helpful in fine-tuning the performance of the module, with attendant benefits in activation or read/write distance (for example).
- A method of forming a module antenna (MA) for a transponder chip module (TCM) may comprise: laser etching a planar antenna (PA) from a conductive layer (CL) or metal layer (ML) on a module tape (MT) or chip carrier tape (CCT) to have tracks separated by spaces; and segmenting a portion of the conductive layer (CL, ML) remaining in an area inside of the planar antenna (PA) to comprise a plurality of small isolated conductive features rather than a single large conductive feature. The etching step may comprise laser etching.
- Fusing the metal layers of a double side tape at hole positions in the glass epoxy tape residing underneath connection bridges, to form through-hole connections (THC).
- In the general context of coupling frames, any metallized surface or conductive layer which is non-transparent to electromagnetic waves can be used to capacitive couple a transponder chip module (TCM) with a contactless reader. The surface, layer or substrate can be metallized plastic or paper, a metal foil, a metal card, a metal slug in a plastic card body, a casing on a mobile telephone, an enclosure protecting a battery, or any type of metal or metallized housing partially surrounding a transponder chip module (TCM) to create an RFID enabled device.

### Some Features Which May Be Incorporated Into Transponder Chip Modules

Some other features disclosed herein (some of which may have been disclosed hereinabove) include or relate to:
- the non-removal of bulk metal such as copper from within an inner area of a planar antenna structure on a module tape (MT) or chip carrier tape (CCT) and profiling or segmenting said metal area through laser or chemical etching, for tuning or reducing the resonance frequency of the planar antenna (PA) when loaded with an RFID chip having a low or high input capacitance. Bulk metal such as copper from within an inner area of a coupling frame on a module tape (MT) or chip carrier tape (CCT) may similarly be profiled or segmented through laser or chemical etching.
- the arrangement of a first metal layer on the face-up side of a module tape (MT) or chip carrier tape (CCT) and a second metal layer on the face-down side of the tape to form a double-sided tape, such as a copper clad glass epoxy tape with a copper layer adhesively attached thereto or a glass epoxy tape with a first metal layer adhesively attached to its top surface (face-up side) and a second metal layer adhesively attached to its bottom surface (face-down side). The thickness of the first copper layer, e.g. 18 µm or 35 µm may be chosen to be thicker than the skin depth of copper at 13.56 MHz, i.e. 17.7 µm while at the same time the thickness of the copper layer may be chosen so that the underside of said first copper layer after plating can be wire bonded without leaving blemishes or indents on its top surface. The thickness of the second copper layer, e.g. 18 µm may be chosen for rapid removal of the copper during laser ablation in forming the planar antenna structure and connection tracks.
- techniques for creating vertical interconnects (vias) between a metal foil layer (e.g. electrodeposited copper or roll annealed copper) adhesively attached to a substrate such as glass epoxy pre-preg tape with a laminated copper layer (copper clad) on its face down side. The copper laminated pre-preg may be provided with punch holes for later bonding of wire connections to the underside of the adhesively attached metal foil layer (usually Ni, Pd and Au plated) to create blind vias or for plated through-holes. These techniques may obviate (or eliminate) the need for plated through-holes. This may include techniques to create vertical interconnects between two opposing metal layers on a substrate such as module tape (MT) or chip carrier tape (CCT) as a replacement for plated through-holes
- techniques for alternative processes to laser ablation of electrodeposited metal foils or roll annealed foils, for antenna structures (module antennas), contact pad arrangements and connection bridges for transponder chip modules (TCM).

Although the invention(s) may have been described mainly in the context of dual-interface RFID devices, having contact (ISO 7816) and contactless (ISO 14443) interfaces, the techniques described herein may have applicability to purely contactless devices, and the devices may employ other or additional communications interfaces.

While the invention(s) has/have been described with respect to a limited number of embodiments, these should not be construed as limitations on the scope of the invention(s), but rather as examples of some of the embodiments. Those skilled in the art may envision other possible variations, modifications, and implementations that are based on the disclosure(s) set forth herein. The scope of the invention is defined in the appended claims.

## Claims

1. A transponder chip module (TCM, 500) comprising:
a first module tape (MT1, 502) having an antenna structure (506) on a bottom surface thereof; and
a second module tape (MT2, 522) having contact pads (CP, 528) on a first, top surface thereof and a connection bridge (CBR, 530) on a second, bottom surface thereof,
the connection bridge being an electrically conductive structure connecting one or both ends of the module antenna with an RFID chip (IC, 508) when the RFID chip is inserted in the transponder chip module;
wherein the second module tape is joined to the first module tape in a stacked manner; and
further comprising conductive elements (532) extending through the second module tape and being aligned with and being in contact with at least some of the contact pads.

2. The transponder chip module of claim 1, further comprising:
through holes (TH, 546) extending through the first module tape and being aligned with the conductive elements extending through the second module tape.

3. The transponder chip module of claim 1, further comprising:
through holes (TH, 542, 544) extending through the first module tape and being aligned with outer and inner portions of the connection bridge.

4. The transponder chip module of claim 1, further comprising:
an opening (OP, 540) extending through the first module tape allowing mounting of the RFID chip (IC, 508) on the second module tape.

5. The transponder chip module of any of the preceding claims, wherein the antenna structure is a planar antenna (PA), particularly the planar antenna having 10 or 11 turns.

6. The transponder chip module of any of the preceding claims, wherein the first module tape is a single-sided copper clad, such as a glass epoxy having a thickness of approximately 70 µm, with a conductive layer (CL, 504) on a bottom side or surface thereof.

7. The transponder chip module of claim 6, wherein the conductive layer (CL, 504) is a copper layer, the copper layer being patterned to be in a form of the antenna structure.

8. The transponder chip module of any of the preceding claims, wherein the second module tape is a double-sided copper clad, such as a glass epoxy having a thickness of approximately 70 µm, with a first conductive layer (CL1, 524) on a top surface thereof and a second conductive layer (CL2, 526) on a bottom surface thereof.

9. The transponder chip module of claim 8, wherein the first and second conductive layers are copper layers, the first conductive layer being patterned to have the contact pads and the second conductive layer being patterned to have the connection bridge.

10. The transponder chip module of claim 1, wherein the connection bridge (CBR, 554) extends around an outer area of the second module tape (MT2, 522) in the manner of a coupling frame (CF, 550) having a slit (S, 552), whereby a portion of the coupling frame serves as the connection bridge.

11. A method of making a transponder chip module (TCM, 500) comprising:
providing a first module tape (MT1, 502) having an antenna structure (506) on a bottom surface thereof;
providing a second module tape (MT2, 522) having contact pads (CP, 528) on a first, top surface thereof and a connection bridge (CBR, 530) on a second, bottom surface thereof,
the connection bridge being an electrically conductive structure connecting one or both ends of the module antenna with an RFID chip (IC, 508) when the RFID chip is inserted in the transponder chip module;
joining the second module tape (MT2) to the first module tape (MT1) in a stacked manner; and
providing conductive elements (532) extending through the second module tape and being aligned with and being in contact with at least some of the contact pads.

12. The method of claim 11, further comprising:
providing through holes (TH, 546) extending through the first module tape and being aligned with the conductive elements extending through the second module tape.

13. The method of claim 11, further comprising:
providing through holes (TH, 542, 544) extending through the first module tape (MT1) and being aligned with outer and inner portions of the connection bridge.

14. The method of claim 11, further comprising:
providing an opening (OP, 540) extending through the first module tape allowing mounting of the RFID chip (IC, 508) on the second module tape.

15. The method of claim 11, wherein through holes (532, 542, 544, 546) in the first and/or the second module tape are provided as follows:
in a first step the module tape is provided with one or more openings (804) in a form of through hole openings, particularly by punching, drilling or laser ablation;
conductive layers (CL, 810, 812) are disposed on a top and a bottom side (802a, 802b) of the module tape;
the conductive layer on one side of the module tape is deformed so that a portion of the conductive layer which is aligned with the through hole opening deforms sufficiently to come into contact with a portion of the conductive layer on the other side of the module tape.

16. The method of claim 16 wherein lasing or welding is employed to fuse the conductive layers together in the through hole.

17. The method of claim 11, wherein through holes (532, 542, 544, 546) in the first and/or the second module tape are provided as follows:
in a first step the module tape is punched to have through hole openings (804);
thereafter a first conductive layer (812) is disposed on only one side of the module tape;
in a next step the first conductive layer is pinched, punched or pressed at a position of the through hole so that it is deformed to extend at least to another surface of the module tape, particularly it extends a few microns beyond the surface;
in another step a second conductive layer (810) is disposed on an opposite side of the module tape; and
finally the conductive layers are mechanically and electrically connected with one another, particularly by resistance welding, ultrasonic bonding or laser welding.

## Patentansprüche

1. Transponderchipmodul (TCM, 500), umfassend:
ein erstes Modulband (MT1, 502) mit einer Antennenstruktur (506) auf einer Unterseite desselben; und
ein zweites Modulband (MT2, 522) mit Kontaktflächen (CP, 528) auf einer ersten, auf einer Oberseite desselben und einer Kontaktierungsbrücke (CBR, 530) auf einer zweiten, auf einer Unterseite desselben,
wobei die Kontaktierungsbrücke eine elektrisch leitfähige Struktur ist, die ein oder beide Enden einer Modulantenne mit einem RFID-Chip (IC, 508) verbindet, wenn der RFID-Chip in das Transponderchipmodul eingesetzt ist;
wobei das zweite Modulband mit dem ersten Modulband in einer gestapelten Weise verbunden ist; und
weiterhin umfassend leitfähige Elemente (532), die sich durch das zweite Modulband erstrecken und die ausgerichtet und in Kontakt gebracht sind mit wenigstens einigen der Kontaktflächen.

2. Transponderchipmodul nach Patentanspruch 1, weiterhin umfassend:
Durchgangsöffnungen (TH, 546), die sich durch das erste Modulband erstrecken und die mit den leitfähigen Elementen ausgerichtet sind, die sich durch das zweite Modulband erstrecken.

3. Transponderchipmodul nach Patentanspruch 1, weiterhin umfassend:
Durchgangsöffnungen (TH, 542, 544), die sich durch das erste Modulband erstrecken und die mit äußeren und inneren Teilen der Kontaktierungsbrücke ausgerichtet sind.

4. Transponderchipmodul nach Patentanspruch 1, weiterhin umfassend:
eine Öffnung (OP, 540), die sich durch das erste Modulband erstreckt und die das Befestigen des RFID-Chips (IC, 508) auf dem zweiten Modulband ermöglicht.

5. Transponderchipmodul nach einem der vorstehenden Patentansprüche, wobei die Antennenstruktur eine Planarantenne (PA) ist, insbesondere eine Planarantenne mit 10 oder 11 Windungen.

6. Transponderchipmodul nach einem der vorstehenden Patentansprüche, wobei das erste Modulband einseitig mit Kupfer laminiert ist, wie zum Beispiel ein Epoxy-Glasgewebe mit einer Stärke von ungefähr 70 µm mit einer leitfähigen Schicht (CL, 504) auf einer Unterseite oder einer Oberseite desselben.

7. Transponderchipmodul nach Patentanspruch 6, wobei die leitfähige Schicht (CL, 504) eine Kupferschicht ist, wobei die Kupferschicht so gemustert ist, dass sie in Form der Antennenstruktur ist.

8. Transponderchipmodul nach einem der vorstehenden Patentansprüche, wobei das zweite Modulband beidseitig mit Kupfer laminiert ist, wie zum Beispiel ein Epoxy-Glasgewebe mit einer Stärke von ungefähr 70 µm mit einer ersten leitfähigen Schicht (CL1, 524) auf einer Oberseite desselben und mit einer zweiten leitfähigen Schicht (CL2, 526) auf einer Unterseite desselben.

9. Transponderchipmodul nach Patentanspruch 8, wobei die ersten und die zweiten leitfähigen Schichten Kupferschichten sind, wobei die erste leitfähige Schicht so gemustert ist, dass sie die Kontaktflächen aufweist, und die zweite leitfähige Schicht so gemustert ist, dass sie die Kontaktierungsbrücke aufweist.

10. Transponderchipmodul nach Patentanspruch 1, wobei die Kontaktierungsbrücke (CBR, 554) sich um einen äußeren Bereich des zweiten Modulbands (MT2, 522) in der Art eines Kopplungsrahmens (CF, 550) mit einem Schlitz (S, 552) herum erstreckt, wobei ein Teil des Kopplungsrahmens als die Kontaktierungsbrücke dient.

11. Verfahren zur Herstellung eines Transponderchipmoduls (TCM, 500), umfassend:
Bereitstellen eines ersten Modulbands (MT1, 502) mit einer Antennenstruktur (506) auf einer Unterseite desselben;
Bereitstellen eines zweiten Modulbands (MT2, 522) mit Kontaktflächen (CP, 528) auf einer ersten, einer Oberseite desselben und mit einer Kontaktierungsbrücke (CBR, 530) auf einer zweiten, einer Unterseite desselben,
wobei die Kontaktierungsbrücke eine elektrisch leitfähige Struktur ist, die ein oder beide Enden einer Modulantenne mit einem RFID-Chip (IC, 508) verbindet, wenn der RFID-Chip in das Transponderchipmodul eingefügt ist;
Verbinden des zweiten Modulbands (MT2) mit dem ersten Modulband (MT1) auf eine gestapelte Art und Weise; und
Bereitstellen von leitfähigen Elementen (532), die sich durch das zweite Modulband hindurch erstrecken und die zumindest mit einigen der Kontaktflächen ausgerichtet sind und mit denselben in Kontakt stehen.

12. Verfahren nach Patentanspruch 11, weiterhin umfassend:
Bereitstellen von Durchgangsöffnungen (TH, 546), die sich durch das erste Modulband hindurch erstrecken und die zu den leitfähigen Elementen ausgerichtet sind, welche sich durch das zweite Modulband hindurch erstrecken.

13. Verfahren nach Patentanspruch 11, weiterhin umfassend:
Bereitstellen von Durchgangsöffnungen (TH, 542, 544), die sich durch das erste Modulband (MT1) hindurch erstrecken und die zu äußeren und inneren Teilen der Kontaktierungsbrücke ausgerichtet sind.

14. Verfahren nach Patentanspruch 11, weiterhin umfassend:
Bereitstellen einer Öffnung (OP, 540), die sich durch das erste Modulband hindurch erstreckt und die das Befestigen des RFID-Chips (IC, 508) auf dem zweiten Modulband ermöglicht.

15. Verfahren nach Patentanspruch 11, wobei Durchgangsöffnungen (532, 542, 544, 546) in dem ersten und/oder in dem zweiten Modulband wie folgt bereitgestellt werden:
in einem ersten Schritt wird das Modulband mit einer oder mehreren Öffnungen (804) in Form von Durchgangsbohrungen versehen, insbesondere durch Stanzen, Bohren oder Laserabtrag;
leitfähige Schichten (CL, 810, 812) werden auf einer Oberseite und auf einer Unterseite (802a, 802b) des Modulbands angeordnet;
die leitfähige Schicht auf einer Seite des Modulbands wird so umgeformt, dass ein Teil der leitfähigen Schicht, die zu der Durchgangsbohrung ausgerichtet ist, sich ausreichend verformt, so dass sie mit einem Teil der leitfähigen Schicht auf der anderen Seite des Modulbands in Kontakt kommt.

16. Verfahren nach Patentanspruch 16, wobei Lasern oder Schweißen genutzt wird, um die leitfähigen Schichten miteinander in der Durchgangsöffnung zu verschmelzen.

17. Verfahren nach Patentanspruch 11, wobei Durchgangsöffnungen (532, 542, 544, 546) in dem ersten und/oder in dem zweiten Modulband wie folgt bereitgestellt werden:
in einem ersten Schritt wird das Modulband gestanzt, um Durchgangsbohrungen (804) zu haben;
anschließend wird eine erste leitfähige Schicht (812) auf nur einer Seite des Modulbands angeordnet;
in einem weiteren Schritt wird die erste leitfähige Schicht in einer Position der Durchgangsöffnung gestaucht, gedrückt oder gepresst, so dass sie sich so weit verformt, dass sie sich wenigstens bis zu einer anderen Oberfläche des Modulbands erstreckt, insbesondere erstreckt sie sich wenige Mikrometer über die Oberfläche hinaus;
in einem weiteren Schritt wird eine zweite leitfähige Schicht (810) auf einer gegenüberliegenden Seite des Modulbands angeordnet; und
schließlich werden die leitfähigen Schichten mechanisch und elektrisch miteinander verbunden, insbesondere durch Widerstandsschweißen, Ultraschallschweißen oder Laserschweißen.

## Revendications

1. Module de puce de transpondeur (TCM, 500) comprenant :
une première bande de module (MT1, 502) munie d'une structure d'antenne (506) sur une surface de dessous de celle-ci ; et
une deuxième bande de module (MT2, 522) munie de plots de contact (CP, 528) sur une première surface de dessus de celle-ci et d'un pont de connexion (CBR, 530) sur une deuxième surface de dessous de celle-ci,
le pont de connexion étant une structure électriquement conductrice connectant une extrémité ou les deux extrémités de l'antenne de module à une puce RFID (IC, 508) lorsque la puce RFID est insérée dans le module de puce de transpondeur ;
dans lequel la deuxième bande de module est assemblée à la première bande de module de manière empilée ; et
comprenant en outre des éléments conducteurs (532) s'étendant à travers la deuxième bande de module et alignés et en contact avec au moins certains des plots de contact.

2. Module de puce de transpondeur selon la revendication 1, comprenant en outre :
des trous traversants (TH, 546) s'étendant à travers la première bande de module et alignés avec les éléments conducteurs s'étendant à travers la deuxième bande de module.

3. Module de puce de transpondeur selon la revendication 1, comprenant en outre :
des trous traversants (TH, 542, 544) s'étendant à travers la première bande de module et alignés avec des parties extérieure et intérieure du pont de connexion.

4. Module de puce de transpondeur selon la revendication 1, comprenant en outre :
une ouverture (OP, 540) s'étendant à travers la première bande de module, qui permet le montage de la puce RFID (IC, 508) sur la deuxième bande de module.

5. Module de puce de transpondeur selon l'une des revendications précédentes, dans lequel la structure d'antenne est une antenne plane (PA), en particulier l'antenne plane ayant 10 ou 11 spires.

6. Module de puce de transpondeur selon l'une des revendications précédentes, dans lequel la première bande de module est un revêtement de cuivre simple face, tel qu'un époxyverre d'une épaisseur d'environ 70 µm muni d'une couche conductrice (CL, 504) sur une surface ou un côté de dessous de celui-ci.

7. Module de puce de transpondeur selon la revendication 6, dans lequel la couche conductrice (CL, 504) est une couche de cuivre, la couche de cuivre étant façonnée pour prendre une forme de la structure d'antenne.

8. Module de puce de transpondeur selon l'une des revendications précédentes, dans lequel la deuxième bande de module est un revêtement de cuivre double face, tel qu'un époxyverre d'une épaisseur d'environ 70 µm muni d'une première couche conductrice (CL1, 524) sur une surface de dessus de celui-ci et d'une deuxième couche conductrice (CL2, 526) sur une surface de dessous de celui-ci.

9. Module de puce de transpondeur selon la revendication 8, dans lequel les première et deuxième couches conductrices sont des couches de cuivre, la première couche conductrice étant façonnée pour comporter les plots de contact et la deuxième couche conductrice étant façonnée pour comporter le pont de connexion.

10. Module de puce de transpondeur selon la revendication 1, dans lequel le pont de connexion (CBR, 554) s'étend autour d'une zone extérieure de la deuxième bande de module (MT2, 522) à la manière d'un cadre de couplage (CF, 550) comportant une fente (S, 552), une partie du cadre de couplage servant ainsi de pont de connexion.

11. Procédé de fabrication d'un module de puce de transpondeur (TCM, 500) comprenant les étapes suivantes :
fournir une première bande de module (MT1, 502) munie d'une structure d'antenne (506) sur une surface de dessous de celle-ci ;
fournir une deuxième bande de module (MT2, 522) munie de plots de contact (CP, 528) sur une première surface, une surface de dessus de celle-ci et d'un pont de connexion (CBR, 530) sur une deuxième surface, une surface de dessous de celle-ci,
le pont de connexion étant une structure électriquement conductrice connectant une extrémité ou les deux extrémités de l'antenne de module à une puce RFID (IC, 508) lorsque la puce RFID est insérée dans le module de puce de transpondeur ;
assembler la deuxième bande de module (MT2) à la première bande de module (MT1) de manière empilée ; et
fournir des éléments conducteurs (532) s'étendant à travers la deuxième bande de module et alignés et en contact avec au moins certains des plots de contact.

12. Procédé selon la revendication 11, comprenant en outre l'étape suivante :
fournir des trous traversants (TH, 546) s'étendant à travers la première bande de module et alignés avec les éléments conducteurs s'étendant à travers la deuxième bande de module.

13. Procédé selon la revendication 11, comprenant en outre l'étape suivante :
fournir des trous traversants (TH, 542, 544) s'étendant à travers la première bande de module (MT1) et alignés avec des parties extérieure et intérieure du pont de connexion.

14. Procédé selon la revendication 11, comprenant en outre l'étape suivante :
fournir une ouverture (OP, 540) s'étendant à travers la première bande de module, qui permet le montage de la puce RFID (IC, 508) sur la deuxième bande de module.

15. Procédé selon la revendication 11, dans lequel les trous traversants (532, 542, 544, 546) dans la première et/ou la deuxième bande de module sont prévus comme suit :
dans une première étape, la bande de module est pourvue d'une ou plusieurs ouvertures (804) sous la forme d'ouvertures de trous traversants, en particulier par poinçonnage, perçage ou ablation au laser ;
des couches conductrices (CL, 810, 812) sont disposées sur un côté de dessus et un côté de dessous (802a, 802b) de la bande de module ;
la couche conductrice sur un côté de la bande de module est déformée de sorte qu'une partie de la couche conductrice qui est alignée avec l'ouverture de trou traversant se déforme suffisamment pour entrer en contact avec une partie de la couche conductrice sur l'autre côté de la bande de module.

16. Procédé selon la revendication 16, dans lequel on emploie le laser ou le soudage pour fondre les couches conductrices ensemble dans le trou traversant.

17. Procédé selon la revendication 11, dans lequel les trous traversants (532, 542, 544, 546) dans la première et/ou la deuxième bande de module sont prévus comme suit :
dans une première étape, la bande de module est poinçonnée pour avoir des ouvertures de trous traversants (804) ;
ensuite, une première couche conductrice (812) est disposée sur un côté seulement de la bande de module ;
dans une étape suivante, la première couche conductrice est pincée, poinçonnée ou pressée au niveau du trou traversant de manière à être déformée pour s'étendre au moins jusqu'à une autre surface de la bande de module, s'étendant en particulier sur quelques microns au-delà de la surface ;
dans une autre étape, une deuxième couche conductrice (810) est disposée sur un côté opposé de la bande de module ; et
enfin, les couches conductrices sont connectées mécaniquement et électriquement les unes aux autres, en particulier par soudage par résistance, liaison par ultrasons ou soudage au laser.
